(19) Europäisches Patentamt
European Patent Office
Office européen des brevets

(11) EP 2 105 796 A1

(12) **EUROPEAN PATENT APPLICATION**

(43) Date of publication:
**30.09.2009 Bulletin 2009/40**

(21) Application number: **09004495.9**

(22) Date of filing: **27.03.2009**

(51) Int Cl.:
***G03F 7/029*** *(2006.01)* ***G03F 7/038*** *(2006.01)*
***G03F 7/11*** *(2006.01)* ***G03F 7/30*** *(2006.01)*
***G03F 7/38*** *(2006.01)* ***G03F 7/40*** *(2006.01)*
***B41C 1/10*** *(2006.01)* *G03F 7/32* *(2006.01)*

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **28.03.2008 JP 2008088772**

(71) Applicant: **FUJIFILM Corporation**
**Minato-ku**
**Tokyo (JP)**

(72) Inventor: **Aoshima, Toshihide**
**Haibara-gun**
**Shizuoka (JP)**

(74) Representative: **HOFFMANN EITLE**
**Patent- und Rechtsanwälte**
**Arabellastrasse 4**
**81925 München (DE)**

(54) **Plate-making method of lithographic printing plate**

(57) A plate-making method of a lithographic printing plate, includes: subjecting a lithographic printing plate precursor comprising, in the following order: a support; an image forming layer; and a protective layer, to image exposure with a laser; and simultaneously removing the protective layer and unexposed area of the image forming layer by an automatic processor in the presence of a developer having pH of from 2 to 10, wherein the image forming layer contains a binder polymer, a polymerizable compound, a polymerization initiator, an acid crosslinking agent and an acid generator.

*FIG. 1*

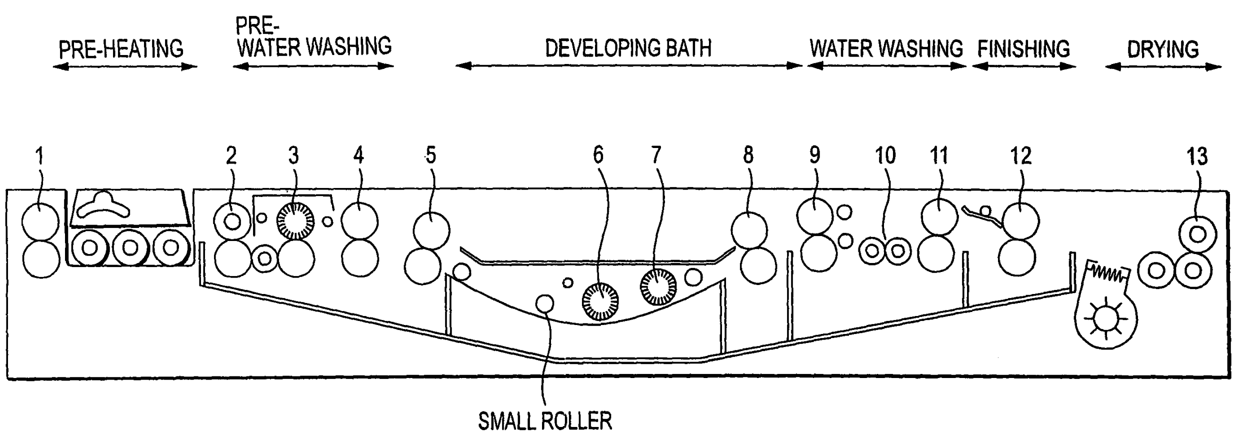


EP 2 105 796 A1

## Description

### FIELD OF THE INVENTION

The present invention relates to a plate-making method of a lithographic printing plate that can be produced by so-called direct plate-making of producing a printing plate directly based on digital signals of a computer or the like by using various lasers.

### BACKGROUND OF THE INVENTION

As for the solid laser, semiconductor laser and gas laser that emit ultraviolet light, visible light or infrared light at a wavelength of 300 to 1,200 nm, a laser having a high output and a small size becomes easily available and such a laser is very useful as a recording light source when making a printing plate directly based on the digital data of a computer or the like. Various studies have been made on the recording material sensitive to light of these lasers. As for the representative recording material, first, a material recordable with an infrared laser having a photosensitive wavelength of 760 nm or more is known, and examples thereof include a positive working recording material described in U.S. Patent 4,708,925 and a negative recording material of acid catalyst crosslinking type described in JP-A-8-276558 (the term "JP-A" as used herein means an "unexamined published Japanese patent application"). Second, a recording material responsive to an ultraviolet or visible light laser having a wavelength of 300 to 700 nm is known, and examples thereof include a large number of recording materials such as radical polymerization-type negative recording material described in U.S. Patent 2,850,445 and JP-B-44-20189 (the term "JP-B" as used herein means an "examined Japanese patent publication").

In processing a conventional lithographic printing plate precursor (hereinafter sometimes referred to as "PS plate"), a step of dissolving and removing the non-image part (development processing) after exposure is indispensable, and a post-processing step of subjecting the printing plate after the development processing to water washing or a treatment with a rinsing solution containing a surfactant or a desensitizing solution containing gum arabic or a starch derivative is also necessary. Conventional PS plates are bound to a large problem that such an additional wet processing is indispensable. Even when the first half (image formation processing) of the plate-making process is simplified by the above-described digital processing, if the last half (development processing) is a cumbersome wet processing, the effect by the simplification is insufficient.

In particular, consideration for global environment is recently a great concern to the entire industry. Also out of consideration to the environment, a processing using a developer closer to the neutral region or reduction in the waste solution is acknowledged as a challenge. In addition, the wet post-processing is preferably simplified or changed to dry processing.

From such a standpoint, as one of the methods for dispensing with the processing step, a method called on-press development is known, where the exposed printing plate precursor is loaded on a cylinder of a printing press and the non-image part of the printing plate precursor is removed by supplying a fountain solution and an ink while rotating the cylinder. That is, this is a system of directly loading the printing plate precursor after exposure on a printing press and completing the development processing in the course of normal printing.

The lithographic printing plate precursor suitable for such on-press development has an image forming layer soluble in a fountain solution or an ink solvent and is required to have bright room handleability suitable for development on a printing press placed in a bright room. However, it is substantially impossible for conventional PS plates to satisfy these requirements.

In order to meet such a requirement, there is proposed a lithographic printing plate precursor where an image forming layer containing hydrophobic thermoplastic polymer fine particles dispersed in a hydrophilic binder polymer is provided on a hydrophilic support (see, for example, Japanese Patent 2,938,397). In the plate-making, the lithographic printing plate precursor which is exposed by an infrared laser to cause coalescence (fusion) of hydrophobic thermoplastic polymer fine particles by the effect of heat generated resulting from photothermal conversion and thereby form an image and then loaded on a cylinder of a printing press can be on-press developed by supplying at least either a fountain solution or an ink. This lithographic printing plate precursor is photosensitive to the infrared region and therefore, also has bright room handleability.

However, the image formed by coalescing (fusing) hydrophobic thermoplastic polymer fine particles is insufficient in the strength, and the printing plate has a problem in terms of press life.

Also, a lithographic printing plate precursor containing a microcapsule enclosing a polymerizable compound, in place of a thermoplastic fine particle, has been proposed (see, for example, JP-A-2000-211262, JP-A-2001-277740, JP-A-2002-29162, JP-A-2002-46361, JP-A-2002-137562 and JP-A-2002-326470). The printing plate precursor in these proposals is advantageous in that the polymer image formed by the reaction of the polymerizable compound is excellent in the strength as compared with the image formed by fusion of fine particles.

Furthermore, since the polymerizable compound has high reactivity, many methods for insulating the polymerizable compound by using a microcapsule have been proposed. As for the shell of the microcapsule, it is proposed to use a heat-decomposable polymer.

However, in the conventional lithographic printing plate precursors described in Japanese Patent 2,938,397, JP-A-2000-211262, JP-A-2001-277740, JP-A-2002-29162, JP-A-2002-46361, JP-A-2002-137562 and JP-A-2002-326470, the image formed by laser exposure is insufficient in the press life, and more improvements are demanded. That is, in such a simple processing-type lithographic printing plate precursor, a support having a surface with high hydrophilicity is used to enable development with an aqueous solution at a pH or 10 or less or with a fountain solution (usually, almost neutral) on a printing press, as a result, the image part is readily separated from the support due to the fountain solution during printing, and a sufficiently high press life is not obtained. Conversely, if the support surface is made hydrophobic, the ink attaches also to the non-image part during printing and printing stain is caused. In this way, it is very difficult to satisfy both the press life and stain resistance, and a simple processing-type lithographic printing plate precursor having good staining resistance and sufficiently high press life has been heretofore not known.

## SUMMARY OF THE INVENTION

Accordingly, an object of the present invention is to provide a plate-making method of producing a lithographic printing plate with excellent press life from a lithographic printing plate precursor capable of being directly processed into a printing plate based on digital data of a computer or the like by performing recording with a solid or semiconductor laser that radiates ultraviolet or visible light, particularly a lithographic printing plate precursor capable of being developed with an aqueous solution at a pH of less than 10 or on a printing press and assured of good performance in terms of sensitivity, developability and staining resistance.

As a result of intensive studies, the present inventors have found that the above-described object can be attained by using the following plate-making method.

(1) A plate-making method of a lithographic printing plate, comprising subjecting a lithographic printing plate precursor having, in order, an image forming layer and a protective layer on a support to image exposure with a laser and then simultaneously removing the protective layer and the image forming layer in the unexposed area by an automatic processor in the presence of a developer at a pH of 2 to 10, the image forming layer containing (a) a binder polymer, (b) a polymerizable compound, (c) a polymerization initiator, (d) an acid crosslinking agent and (e) an acid generator.

(2) The plate-making method of a lithographic printing plate as described in (1), wherein the binder polymer (a) has a hydrophilic group.

(3) The plate-making method of a lithographic printing plate as described in (2), wherein the hydrophilic group is at least one member selected from a primary amino group, a secondary amino group, a tertiary amino group, a salt obtained by neutralizing an amino group with an acid, a quaternary ammonium group, an amide group, a hydroxy group, and a salt obtained by neutralizing a carboxylic acid with an ammonium group.

(4) The plate-making method of a lithographic printing plate as described in any one of (1) to (3), wherein the acid crosslinking agent (d) is a nitrogen-containing crosslinking agent.

(5) The plate-making method of a lithographic printing plate as described in any one of (1) to (4), wherein the acid generator (e) is an onium salt.

(6) The plate-making method of a lithographic printing plate as described in any one of (1) to (5), wherein the image forming layer further contains (f) a sensitizing dye.

(7) The plate-making method of a lithographic printing plate as described in any one of (1) to (6), wherein the lithographic printing plate precursor after image exposure with a laser is heat-treated and then subjected to removal of the image forming layer in the unexposed area in the presence of a developer at a pH of 2 to 10.

(8) The plate-making method of a lithographic printing plate as described in any one of (1) to (6), wherein the lithographic printing plate precursor after image exposure with a laser is subjected to removal of the image forming layer in the unexposed area in the presence of a developer at a pH of 2 to 10 and then heat-treated.

The operation mechanism of the present invention is presumed as follows.

That is, in the present invention, a substance capable of generating an acid by the effect of heat is added to the photosensitive resin composition requiring heat curing, and the curing reaction is accelerated by an acid generated when practicing the curing step under heat. By such hybridization of radical polymerization and cationic polymerization, the crosslinking density in the image forming layer is enhanced and an image forming layer with low water permeability is formed. Accordingly, the fountain solution during printing can be prevented from penetrating into the image forming layer and high press life can be obtained.

According to the present invention, a plate-making method of a lithographic printing plate, where a printing plate with excellent press life can be directly produced by plate-making based on digital signals of a computer or the

like by using various lasers, that is, so-called direct plate-making can be performed, and where high productivity, good performance in terms of developability and staining resistance and in particular, excellent sensitivity are ensured, can be provided.

## BRIEF DESCRIPTION OF THE DRAWINGS

Fig. 1 is an explanatory view showing the structure of an automatic developing processor.

[Description of Reference Numerals and Signs]

1: Conveying roller pair
2: Conveying roller pair
3: Rotating brush roller
4: Conveying roller pair
5: Conveying roller pair
6: Rotating brush roller
7: Rotating brush roller
8: Conveying roller pair
9: Conveying roller pair
10: Backing roller
11: Conveying roller pair
12: Conveying roller pair
13: Conveying roller pair

## DETAILED DESCRIPTION OF THE INVENTION

The plate-making method of a lithographic printing plate of the present invention is described in detail below.
The lithographic printing plate precursor for use in the plate-making method of the present invention has, in order, an image forming layer and a protective layer on a support, the image forming layer containing (a) a hydrophilic polymer, (b) a polymerizable compound, (c) a polymerization initiator, (d) an acid crosslinking agent and (e) an acid generator.
These are further described in detail below.

<(a) Binder Polymer>

As for the binder polymer usable in the image forming layer of the present invention, in view of developability with a developer, a hydrophilic polymer having a hydrophilic group is preferably used.
The hydrophilic group is selected from a primary hydrophilic group and a secondary or greater hydrophilic group and is preferably, for example, a hydroxy group, a sulfonic acid group, a carboxylic acid group, a phosphoric acid group, an alkyleneoxy group such as ethyleneoxy group or propyleneoxy group, a primary amino group, a secondary amino group, a tertiary amino group, a salt obtained by neutralizing an amino group with an acid, a quaternary ammonium group, a sulfonium group, an iodonium group, a phosphonium group, an amide group, an ether group, or a salt obtained by neutralizing an acid group such as carboxylic acid, sulfonic acid or phosphoric acid, more preferably a primary amino group, a secondary amino group, a tertiary amino group, a salt obtained by neutralizing an amino group with an acid, a quaternary ammonium salt, an amido group, a hydroxy group, a $-CH_2CH_2O-$ repeating unit, or a $-CH_2CH_2NH-$ repeating unit, still more preferably a primary amino group, a secondary amino group, a tertiary amino group, a salt obtained by neutralizing an amino group with an acid, a quaternary ammonium salt, an amide group, a hydroxy group, or a salt obtained by neutralizing a carboxylic acid with an ammonium group.
The binder polymer is preferably a copolymer, and the ratio of the above-described hydrophilic group-containing copolymerization component occupying in all copolymerization components of the copolymer is, in view of developability, preferably from 1 to 70%, and from the standpoint of satisfying both the developability and press life, more preferably from 1 to 50%, still more preferably from 1 to 30%.
Furthermore, in view of developability and staining resistance, the binder polymer usable in the present invention preferably contains substantially no carboxylic acid group and no phosphoric acid group.

The acid value of the binder polymer (the percentage acid content per g of polymer, expressed by the chemical equivalent number) is preferably 0.3 meq/g or less, more preferably 0.1 meq/g or less.

Also, the binder polymer for use in the present invention is preferably insoluble in water or an aqueous solution at a pH of 10 or more. The solubility of the binder polymer in water (the concentration of the binder polymer at the saturated dissolution) is preferably 10 mass% or less, more preferably 1.0 mass% or less. Incidentally, the temperature when measuring the solubility is 25˚C which is a normal temperature at the development in plate-making.

As for the skeleton of the binder polymer, a polymer selected from an acrylic resin, a polyvinyl acetal resin, a polyvinyl alcohol resin, a polyurethane resin, a polyamide resin, an epoxy resin, a methacrylic resin, a styrene-based resin and a polyester resin is preferred. Above all, a vinyl copolymer such as acrylic resin, methacrylic resin or styrene-based resin, or a polyurethane resin is preferred.

The binder polymer for use in the present invention preferably has a crosslinking group. The crosslinking group as used herein means a group capable of crosslinking the binder polymer in the course of radical polymerization reaction occurring in the image forming layer when the lithographic printing plate precursor is exposed. The crosslinking group is not particularly limited as long as it has such a function, but examples of the functional group capable of undergoing an addition-polymerization reaction include an ethylenically unsaturated bond group, an amino group and an epoxy group. The crosslinking group may also be a functional group which can be converted into a radical upon irradiation with light, and examples of such a crosslinking group include a thiol group and a halogen group. Among these, an ethylenically unsaturated bond group is preferred. The ethylenically unsaturated bond group is preferably a styryl group, a (meth)acryloyl group or an allyl group.

In the binder polymer, for example, a free radical (a polymerization initiating radical or a radical grown in the course of polymerization of the polymerizable compound) is added to the crosslinking functional group to cause an addition-polymerization between polymers directly or through a polymerization chain of the polymerizable compound, as a result, crosslinking is formed between polymer molecules and curing is thereby effected. Alternatively, an atom (for example, a hydrogen atom on the carbon atom adjacent to the functional crosslinkable group) in the polymer is withdrawn by a free radical to produce a polymer radical, and the polymer radicals combine with each other, as a result, crosslinking is formed between polymer molecules and curing is thereby effected.

The content of the crosslinking group (content of the radical-polymerizable unsaturated double bond determined by iodine titration) in the binder polymer is preferably from 0.01 to 10.0 mmol, more preferably from 0.05 to 5.0 mmol, and most preferably from 0.1 to 2.0 mmol, per g of the binder polymer.

Furthermore, from the standpoint of enhancing the press life, the crosslinking group is preferably present in the vicinity of the hydrophilic group, and the hydrophilic group and the crosslinking group may be present on the same polymerization unit.

The binder polymer for use in the present invention preferably has an alkyl or aralkyl (meth)acrylate unit, in addition to the unit having a hydrophilic group and the unit having a crosslinking group. The alkyl group of the alkyl (meth)acrylate is preferably an alkyl group having a carbon number of 1 to 5, more preferably a methyl group. Examples of the aralkyl (meth)acrylate include benzyl (meth)acrylate.

The binder polymer preferably has a mass average molecular weight of 5,000 or more, more preferably from 10,000 to 300,000, and a number average molecular weight of 1,000 or more, more preferably from 2,000 to 250,000. The polydispersity (mass average molecular weight/number average molecular weight) is preferably from 1.1 to 10.

The binder polymer may be any of a random polymer, a block polymer, a graft polymer and the like.

One of the binder polymer may be used alone, or two or more kinds thereof may be mixed and used. In view of good strength of the image part and good image formability, the content of the binder polymer is preferably from 5 to 75 mass%, more preferably from 10 to 70 mass%, still more preferably from 10 to 60 mass%, based on the entire solid content of the image forming layer.

The total content of the polymerizable compound and the binder polymer is preferably 80 mass% or less based on the entire solid content of the image forming layer. If the total content exceeds 80 mass%, this may cause reduction in the sensitivity or reduction in the developability. The total content is more preferably from 35 to 75 mass%.

Specific examples of the polymerization unit constituting the binder polymer and specific examples of the binder polymer for use in the present invention are set forth below, but the present invention is not limited to these examples.

Specific examples of the binder polymer added are set forth below, but the binder polymer added is not limited thereto. In the Table, the mass average molecular weight (Mw) is a value measured by gas permeation chromatography (GPC) using polystyrene as a standard substance.

| Polymer No. | Binder Structure (mol%) | Molecular Weight |
|---|---|---|
| P-1 | 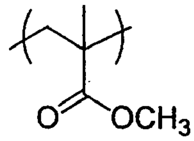 90 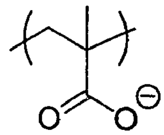 10 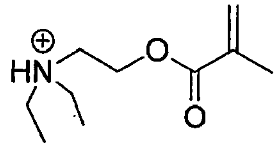 | 80000 |
| P-2 | 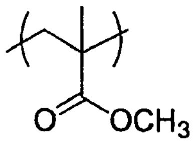 95 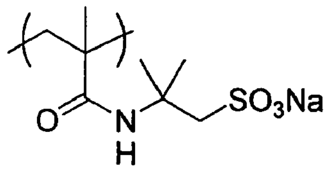 5 | 72000 |

| Polymer No. | Diisocyanate Compound Used (mol%) | Diol Compound Used (mol%) | Molecular Weight |
|---|---|---|---|
| P-3 | 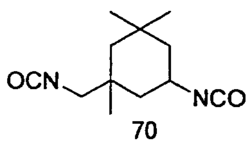 70 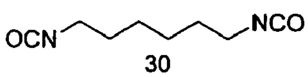 30 | 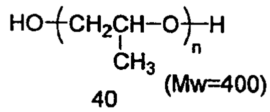 (Mw=400) 40 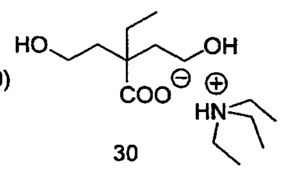 30 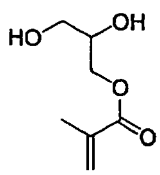 30 | 60000 |

| Polymer No. | Binder Structure (mol%) | Molecular Weight |
|---|---|---|
| P - 4 | 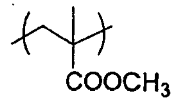 90 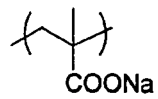 10 | 50000 |
| P - 5 | 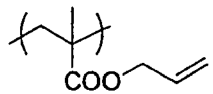 90 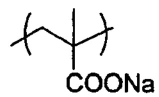 10 | 60000 |
| P - 6 | 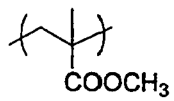 65 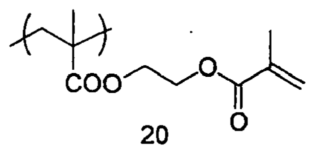 20 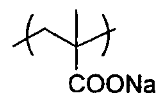 15 | 65000 |
| P - 7 | 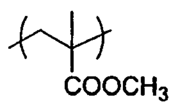 85 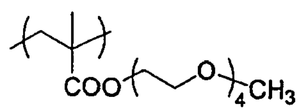 10 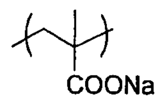 5 | 60000 |
| P - 8 | 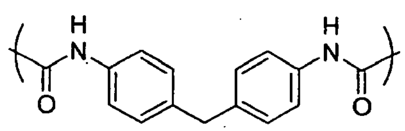 40 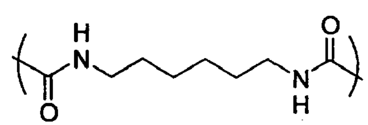 10 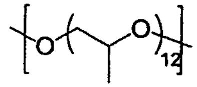 20 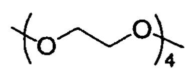 20 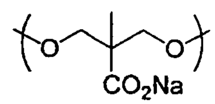 10 | 63000 |

(continued)

| Polymer No. | Binder Structure (mol%) | | Molecular Weight |
|---|---|---|---|
| P - 9 | 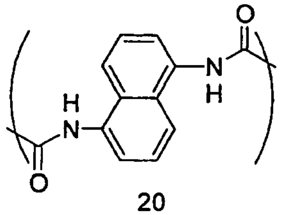 20 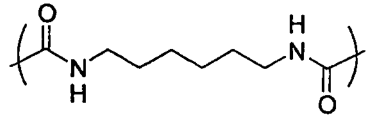 30 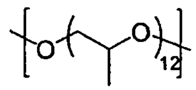 20 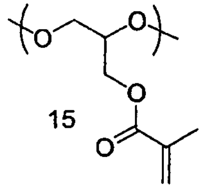 15 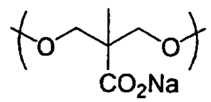 15 | | 60000 |
| P - 10 | 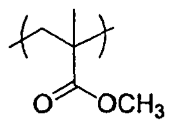 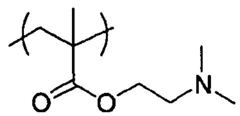 | 90/10 | 70000 |
| P - 11 | 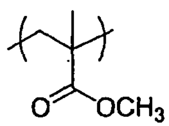 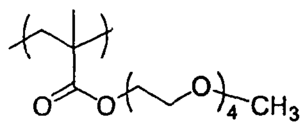 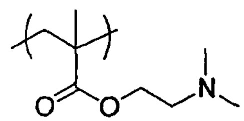 | 90/5/5 | 80000 |
| P - 12 | 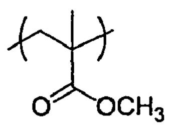 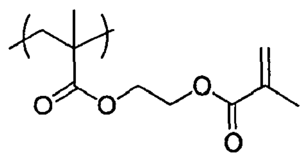 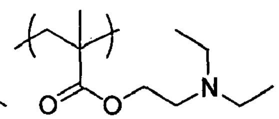 | 60/35/5 | 80000 |

| Polymer No. | Diisocyanate Compound Used (mol%) | Diol Compound Used (mol%) | Molecular Weight |
|---|---|---|---|
| P - 13 | 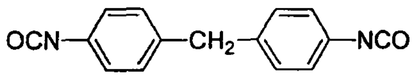 80 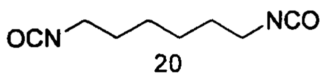 20 | 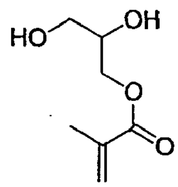 30 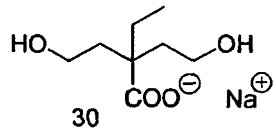 30 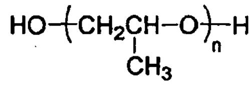 40 (Mw=400) | 57000 |

| Polymer No. | Polymer Structure | Compositional Ratio | Molecular Weight |
|---|---|---|---|
| P-14 | 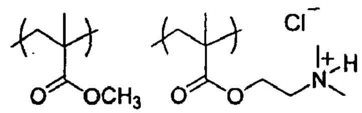 | 90/10 | 70000 |
| P-15 | 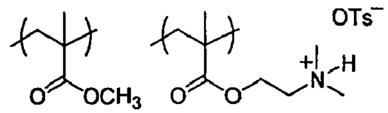 | 90/10 | 58000 |
| P-16 | 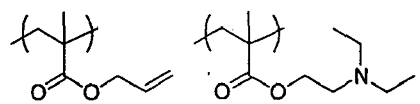 | 90/10 | 90000 |
| P-17 | 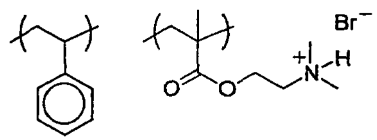 | 70/30 | 62000 |
| P-18 | 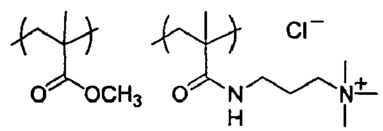 | 70/30 | 58000 |
| P-19 | 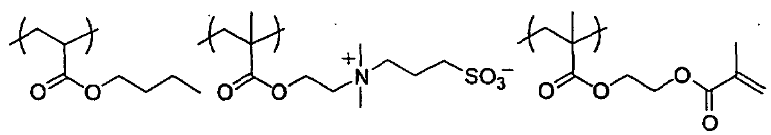 | 50/25/25 | 49000 |

| | Diisocyanate Dicarboxylic Acid Structure | | Diol Diamine Structure | | | Mw |
|---|---|---|---|---|---|---|
| P-20 | 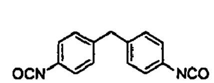 40 | 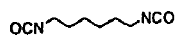 10 | 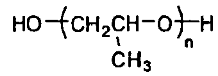 10 (Mw=1000) | 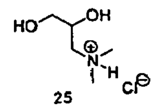 25 | 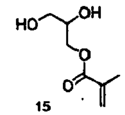 15 | 59000 |
| P-21 | 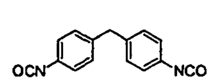 40 | 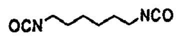 10 | 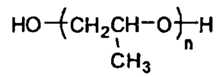 10 (Mw=1000) | 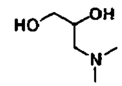 25 | 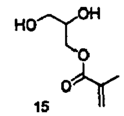 15 | 59000 |
| P-22 | 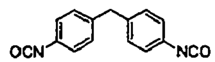 40 | 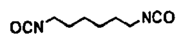 10 | 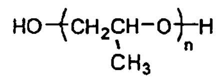 10 (Mw=1000) | 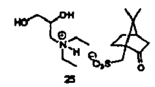 25 | 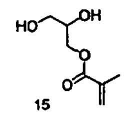 15 | 62000 |
| P-23 | 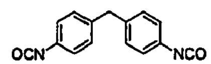 40 | 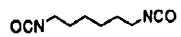 10 | 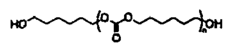 10 | 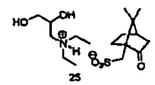 25 | 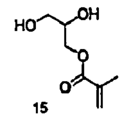 15 | 53000 |

| | Binder Structure | Mw |
|---|---|---|
| P - 24 | 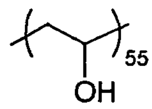 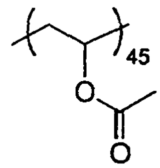 | 80000 |
| P - 25 | 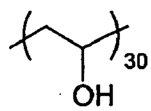 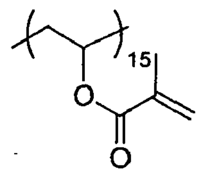 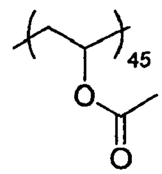 | 100000 |

(b) Polymerizable Compound

The polymerizable monomer for use in the image forming layer in the present invention is an addition-polymerizable compound having at least one ethylenically unsaturated double bond and is selected from compounds having at least one, preferably two or more, terminal ethylenically unsaturated bond(s). Such compounds are widely known in this industrial field and these known compounds can be used in the present invention without any particular limitation. These compounds have a chemical form such as monomer, prepolymer (that is, dimer, trimer or oligomer) or a copolymer or mixture thereof. Examples of the monomer include an unsaturated carboxylic acid (e.g., acrylic acid, methacrylic acid, itaconic acid, crotonic acid, isocrotonic acid, maleic acid), and esters and amides thereof. Among these, preferred are esters of an unsaturated carboxylic acid with an aliphatic polyhydric alcohol compound, and amides of an unsaturated carboxylic acid with an aliphatic polyvalent amine compound. Also, for example, an addition reaction product of unsaturated carboxylic acid esters or amides having a nucleophilic substituent such as hydroxyl group, amino group or mercapto group with monofunctional or polyfunctional isocyanates or epoxies, and a dehydrating condensation reaction product with a monofunctional or polyfunctional carboxylic acid may be suitably used. Furthermore, an addition reaction product of unsaturated carboxylic acid esters or amides having an electrophilic substituent such as isocyanate group or epoxy group with monofunctional or polyfunctional alcohols, amines or thiols, and a displacement reaction product of unsaturated carboxylic acid esters or amides having a leaving substituent such as halogen group or tosyloxy group with monofunctional or polyfunctional alcohols, amines or thiols may also be suitably used. In addition, compounds where the unsaturated carboxylic acid of the above-described compounds is replaced by an unsaturated phosphonic acid, styrene, vinyl ether or the like, may also be used.

Specific examples of the ester monomer of an aliphatic polyhydric alcohol compound with an unsaturated carboxylic acid include the followings. Examples of the acrylic acid ester include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl)isocyanurate, isocyanuric acid ethylene oxide (EO)-modified triacrylate, and polyester acrylate oligomer.

Examples of the methacrylic acid ester include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)-phenyl] dimethylmethane and bis[p-(methacryloxyethoxy)phenyl]dimethylmethane.

Examples of the itaconic acid ester include ethylene glycol diitaconate, propylene glycol diitaconate, 1,3-butanediol diitaconate, 1,4-butanediol diitaconate, tetramethylene glycol diitaconate, pentaerythritol diitaconate and sorbitol tetraitaconate. Examples of the crotonic acid ester include ethylene glycol dicrotonate, tetramethylene glycol dicrotonate, pentaerythritol dicrotonate and sorbitol tetradicrotonate. Examples of the isocrotonic acid ester include ethylene glycol diisocrotonate, pentaerythritol diisocrotonate and sorbitol tetraisocrotonate. Examples of the maleic acid ester include ethylene glycol dimaleate, triethylene glycol dimaleate, pentaerythritol dimaleate and sorbitol tetramaleate.

Other examples of the ester which can be suitably used include aliphatic alcohol-based esters described in

JP-B-51-47334 and JP-A-57-196231, those having an aromatic skeleton described in JP-A-59-5240, JP-A-59-5241 and JP-A-2-226149, and those containing an amino group described in JP-A-1-165613.

These ester monomers may also be used as a mixture.

Specific examples of the amide monomer of an aliphatic polyvalent amine compound with an unsaturated carboxylic acid include methylenebis-acrylamide, methylenebis-methacrylamide, 1,6-hexamethylenebis-acrylamide, 1,6-hexamethylenebis-methacrylamide, diethylenetriaminetrisacrylamide, xylylenebisacrylamide and xylylenebismethacrylamide. Other preferred examples of the amide-type monomer include those having a cyclohexylene structure described in JP-B-54-21726.

A urethane-based addition-polymerizable compound produced using an addition reaction of isocyanate with hydroxyl group is also preferred, and specific examples thereof include a vinyl urethane compound having two or more polymerizable vinyl groups within one molecule described in JP-B-48-41708, which is obtained by adding a vinyl monomer having a hydroxyl group represented by the following formula (A) to a polyisocyanate compound having two or more isocyanate groups within one molecule:

$$CH_2=C(R_4)COOCH_2CH(R_5)OH \qquad (A)$$

(wherein $R_4$ and $R_5$ each represents H or $CH_3$).

In addition, urethane acrylates described in JP-A-51-37193, JP-B-2-32293 and JP-B-2-16765, and urethane compounds having an ethylene oxide-type skeleton described in JP-B-58-49860, JP-B-56-17654, JP-B-62-39417 and JP-B-62-39418 are also suitably used. Furthermore, when addition-polymerizable compounds having an amino or sulfide structure within the molecule described in JP-A-63-277653, JP-A-63-260909 and JP-A-1-105238 are used, a photopolymerizable composition having very excellent photosensitization speed can be obtained.

Other examples include a polyfunctional acrylate or methacrylate such as polyester acrylates described in JP-A-48-64183, JP-B-49-43191 and JP-B-52-30490 and epoxy acrylates obtained by reacting an epoxy resin with a (meth) acrylic acid. Also, a specific unsaturated compound described in JP-B-46-43946, JP-B-1-40337 and JP-B-1-40336, a vinyl phosphonic acid-based compound described in JP-A-2-25493, or the like may be used. In some cases, a structure containing a perfluoroalkyl group described in JP-A-61-22048 is suitably used. Furthermore, those described as a photocurable monomer or oligomer in Adhesion, Vol. 20, No. 7, pp. 300-308 (1984) may also be used.

Details of the use method of these polymerizable compounds, such as structure, sole or combination use and amount added, can be freely selected in accordance with the performance design of the final lithographic printing plate precursor and, for example, may be selected from the following standpoints.

In view of sensitivity, a structure having a large unsaturated group content per one molecule is preferred and in most cases, a bifunctional or greater functional compound is preferred. For increasing the strength of image part, namely, cured film, a trifunctional or greater functional compound is preferred. Also, a method of controlling both sensitivity and strength by using a combination of compounds differing in the functional number or in the polymerizable group (for example, an acrylic acid ester, a methacrylic acid ester, a styrene-based compound or a vinyl ether-based compound) is effective.

The selection and use method of the polymerizable compound are important factors also in view of compatibility and dispersibility with other components (e.g., binder polymer, polymerization initiator, colorant) in the image forming layer. For example, the compatibility may be enhanced by using a low purity compound or using two or more kinds of compounds in combination. Also, a specific structure may be selected for the purpose of enhancing the adherence to the support, protective layer which is described later, or the like. Other than these, as for the use method of the polymerizable compound, an appropriate structure, formulation or amount added may be freely selected by taking into account the degree of polymerization inhibition due to oxygen, resolution, fogging, change in refractive index, surface tackiness and the like. Depending on the case, such a layer structure or a coating method as undercoat and overcoat may also be employed.

The polymerizable compound is preferably used in an amount of 5 to 75 mass%, more preferably from 25 to 70 mass%, still more preferably from 30 to 60 mass%, based on entire solid content of the image forming layer.

(c) Polymerization Initiator

The image forming layer for use in the present invention contains a polymerization initiator (hereinafter, sometimes referred to as an "initiator compound"). The initiator compound is a compound of causing a chemical change under the action attributable to the electron-excited state of a sensitizing dye, such as electron transfer, energy transfer or heat generation, and producing at least one member selected from a radical, an acid and a base. Hereinafter, the radical, acid or base produced in this way is simply referred to as an active species. In the case where the initiator compound is not present or only the initiator compound is used alone, sufficiently high sensitivity cannot be obtained in practice. In one embodiment of using a sensitizing dye and an initiator compound in combination, these may be used as a single

compound by employing an appropriate chemical method (for example, linkage of a sensitizing dye and an initiator compound through a chemical bond).

Many of these initiator compounds are considered to usually produce an active species through an initial chemical process as represented by the following (1), (2) or (3), that is, (1) reductive decomposition of the initiator compound based on the electron transfer reaction from the electron-excited state of a sensitizing dye to the initiator compound, (2) oxidative decomposition of the initiator compound based on the electron transfer from the initiator compound to the electron-excited state of a sensitizing dye, or (3) decomposition from the electron-excited state of the initiator compound based on the energy transfer from the electron-excited state of a sensitizing dye to the initiator compound. To which type of (1) to (3) individual initiator compounds belong is unclear in many cases, but the sensitizing dye for use in the present invention exhibits a very high sensitizing effect when combined with any type of the initiator compound.

As to the initiator compound for use in the present invention, those known to one skilled in the art can be used without limitation, and specific examples thereof include a trihalomethyl compound, a carbonyl compound, an organic peroxide, an azo-based compound, an azide compound, a metallocene compound, a hexaarylbiimidazole compound, an organoboron compound, a disulfone compound, an oxime ester compound, an onium salt compound and an iron-arene complex. Above all, the initiator compound is preferably at least one member selected from the group consisting of a hexaarylbiimidazole-based compound, an onium salt, a trihalomethyl compound and a metallocene compound, more preferably a hexaarylbiimidazole-based compound. Two ore more kinds of these polymerization initiators may be appropriately used in combination.

Examples of the hexaarylbiimidazole-based compound include lophine dimers described in JP-B-45-37377 and JP-B-44-86516, such as 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole, and 2,2'-bis(o-trifluorophenyl)-4,4',5,5'-tetraphenylbiimidazole.

The hexaarylbiimidazole-based compound is preferably used in combination particularly with a sensitizing dye having maximum absorption at 300 to 450 nm.

The onium salt (in the present invention, acts as an ionic polymerization initiator but not as an acid generator) suitably used in the present invention is an onium salt represented by any one of the following formulae (RI-I) to (RI-III):

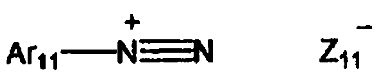
(RI-I)

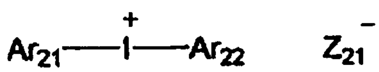
(RI-II)

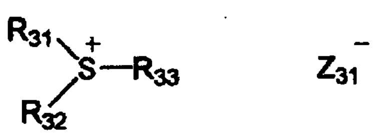
(RI-III)

In formula (RI-I), $Ar_{11}$ represents an aryl group having a carbon number of 20 or less, which may have from 1 to 6 substituents, and preferred examples of the substituent include an alkyl group having a carbon number of 1 to 12, an alkenyl group having a carbon number of 1 to 12, an alkynyl group having a carbon number of 1 to 12, an aryl group having a carbon number of 1 to 12, an alkoxy group having a carbon number of 1 to 12, an aryloxy group having a carbon number of 1 to 12, a halogen atom, an alkylamino group having a carbon number of 1 to 12, a dialkylamino group having a carbon number of 1 to 12, an alkylamido or arylamido group having a carbon number of 1 to 12, a carbonyl group, a carboxyl group, a cyano group, a sulfonyl group, a thioalkyl group having a carbon number of 1 to 12, and a thioaryl group having a carbon number of 1 to 12. $Z^{11-}$ represents a monovalent anion and is specifically a halogen ion, a perchlorate ion, a hexafluorophosphate ion, a tetrafluoroborate ion, a sulfonate ion, a sulfinate ion, a thiosulfonate ion

or a sulfate ion. In view of stability, the anion is preferably a perchlorate ion, a hexafluorophosphate ion, a tetrafluoroborate ion, a sulfonate ion or a sulfinate ion.

In formula (RI-II), $Ar_{21}$ and $Ar_{22}$ each independently represents an aryl group having a carbon number of 20 or less, which may have from 1 to 6 substituents, and preferred examples of the substituent include an alkyl group having a carbon number of 1 to 12, an alkenyl group having a carbon number of 1 to 12, an alkynyl group having a carbon number of 1 to 12, an aryl group having a carbon number of 1 to 12, an alkoxy group having a carbon number of 1 to 12, an aryloxy group having a carbon number of 1 to 12, a halogen atom, an alkylamino group having a carbon number of 1 to 12, a dialkylamino group having a carbon number of 1 to 12, an alkylamido or arylamido group having a carbon number of 1 to 12, a carbonyl group, a carboxyl group, a cyano group, a sulfonyl group, a thioalkyl group having a carbon number of 1 to 12, and a thioaryl group having a carbon number of 1 to 12. $Z_{21}^-$ represents a monovalent anion and is specifically a halogen ion, a perchlorate ion, a hexafluorophosphate ion, a tetrafluoroborate ion, a sulfonate ion, a sulfinate ion, a thiosulfonate ion or a sulfate ion. In view of stability and reactivity, the anion is preferably a perchlorate ion, a hexafluorophosphate ion, a tetrafluoroborate ion, a sulfonate ion, a sulfinate ion or a carboxylate ion.

In formula (RI-III), $R_{31}$, $R_{32}$ and $R_{33}$ each independently represents an aryl, alkyl, alkenyl or alkynyl group having a carbon number of 20 or less, which may have from 1 to 6 substituents, and in view of reactivity and stability, is preferably an aryl group. Examples of the substituent include an alkyl group having a carbon number of 1 to 12, an alkenyl group having a carbon number of 1 to 12, an alkynyl group having a carbon number of 1 to 12, an aryl group having a carbon number of 1 to 12, an alkoxy group having a carbon number of 1 to 12, an aryloxy group having a carbon number of 1 to 12, a halogen atom, an alkylamino group having a carbon number of 1 to 12, a dialkylamino group having a carbon number of 1 to 12, an alkylamido or arylamido group having a carbon number of 1 to 12, a carbonyl group, a carboxyl group, a cyano group, a sulfonyl group, a thioalkyl group having a carbon number of 1 to 12, and a thioaryl group having a carbon number of 1 to 12. $Z_{31}^-$ represents a monovalent anion and is specifically a halogen ion, a perchlorate ion, a hexafluorophosphate ion, a tetrafluoroborate ion, a sulfonate ion, a sulfinate ion, a thiosulfonate ion or a sulfate ion. In view of stability and reactivity, the anion is preferably a perchlorate ion, a hexafluorophosphate ion, a tetrafluoroborate ion, a sulfonate ion, a sulfinate ion or a carboxylate ion, more preferably a carboxylate ion described in JP-A-2001-343742, still more preferably a carboxylate ion described in JP-A-2002-148790.

The onium ion is preferably used in combination particularly with an infrared absorbent having maximum absorption at 750 to 1,400 nm.

As for other polymerization initiators, the polymerization initiators described in JP-A-2007-171406, JP-A-2007-206216, JP-A-2007-206217, JP-A-2007-225701, JP-A-2007-225702, JP-A-2007-316582 and JP-A-2007-328243 may also be preferably used.

The polymerization initiators for use in the present invention may be suitably used individually or in combination of two or more thereof.

The amount of the polymerization initiator in the image forming layer in the present invention is preferably from 0.01 to 20 mass%, more preferably from 0.1 to 15 mass%, still more preferably from 1.0 to 10 mass%, based on the mass of all solid contents in the image forming layer.

(d) Acid Crosslinking Agent

The acid crosslinking agent (d) used as one component in the photosensitive resin composition includes, for example, a compound having, within one molecule, two or more functional groups which are one or more kinds of functional groups having reactivity with the active hydrogen atom-containing group (e.g., carboxyl group, hydroxyl group, primary amino group, secondary amino group) in the hydrophilic polymer (a) (hereinafter referred to as a "crosslinking functional group").

Specific examples of the crosslinking functional group include the following functional groups of which reaction with the active hydrogen atom-containing group is accelerated by using an acid as the catalyst:

(i) Hydroxyl Group-Containing Functional Groups

A methylol group, a dimethylolaminomethyl group, a diethylolaminomethyl group, etc.

(ii) Nitrogen Atom-Containing Functional Groups

An oxazoline group, an imidazolium group, a dimethylaminomethyl group, a diethylaminomethyl group,

(iii) Ether Group-Containing Functional Groups

A methoxymethyl group, an ethoxymethyl group, a benzyloxymethyl group, an acetoxymethyl group, a benzoyloxymethyl group, a morpholinomethyl group, etc.

(iv) Glycidyl Group-Containing Functional Groups

A glycidyl ether group, a glycidyl ester group, a glycidylamino group, etc.
Among these, (i) hydroxyl group-containing functional groups, (ii) nitrogen atom-containing functional groups and (iii) ether group-containing functional group are preferred, a methylol group, an oxazoline group and a methoxymethyl group are more preferred, and a methylol group is till more preferred.
Examples of the acid crosslinking agent (d) include the followings.

(i) Methylol Group-Containing Compound

A methylol group-containing melamine compound, a methylol group-containing benzoguanamine compound, a methylol group-containing urea compound, a methylol group-containing phenol compound, etc.

(ii) Methylol Group-Containing Resin

A methylol group-containing melamine resin, a methylol group-containing benzoguanamine resin, a methylol group-containing urea resin, a methylol group-containing phenol resin, etc.

(iii) Oxazoline Group-Containing Compound

Methyloxazoline, ethyloxazoline, etc.

(iv) Oxazoline Group-Containing Resin

An oxazoline group-containing (meth)acrylic resin, an oxazoline group-containing styrene resin, etc.

(v) Methoxymethyl Group-Containing Compound

A methoxymethyl group-containing melamine compound, a methoxymethyl group-containing benzoguanamine compound, a methoxymethyl group-containing urea compound, a methoxymethyl group-containing phenol compound, etc.

(vi) Methoxymethyl Group-Containing Resin

A methoxymethyl group-containing melamine resin, a methoxymethyl group-containing benzoguanamine resin, a methoxymethyl group-containing urea resin, a methoxymethyl group-containing phenol resin, etc.
One member or two or more members of these functional groups may be used.
Among these compounds having a crosslinking functional group, a methylol group-containing compound and an oxazoline group-containing compound are preferred, an oxazoline group-containing acrylic resin, a methylol group-containing phenol compound and a methylol group-containing melamine compound are more preferred, and a methylol group-containing melamine compound is still more preferred.
In view of curability, the content of the acid crosslinking agent (d) is preferably from 0.1 to 20%, more preferably from 0.5 to 15%, still more preferably from 1 to 10%, based on the mass of solid contents of the photosensitive resin composition.

(e) Acid Generator

In the present invention, the acid generator is a compound that decomposes under heating at 100°C or more to generate an acid. The acid generated is preferably a strong acid having a pKa of 2 or less, such as sulfonic acid or hydrochloric acid. Examples of the acid generator suitably used in the present invention include an onium salt such as iodonium salt, sulfonium salt, phosphonium salt and diazonium salt. Specific examples thereof include the compounds described in JP-A-7-20629. In particular, an iodonium salt, a sulfonium salt and a diazonium salt are preferred. Furthermore, haloalkyl-substituted s-triazines described in JP-A-7-271029 are also preferred.
In addition, an acid generator described in JP-A-11-119421 may also be preferably used.
Acid generators described in JP-A-10-16423 previously filed by the applicant of the present invention, and polymer-type acid generators described in JP-A-9-197671 are also preferred.

Such a compound is added in the image forming layer in a ratio of generally from 0.01 to 50 mass%, preferably from 0.1 to 25 mass%, more preferably from 0.5 to 15 mass%, based on the entire solid content of the image forming layer. If the amount added is less than 0.01 mass%, an image may not be obtained, whereas if the amount added exceeds 50 mass%, staining may occur in the non-image part during printing.

One of these compounds may be used alone, or two or more kinds thereof may be used in combination.

(f) Sensitizing Dye

The photosensitive layer for use in the present invention contains a sensitizing dye. For example, high-sensitivity lithographic printing plates responsive to a violet laser of 405 nm, a green laser of 532 nm and an IR laser of 803 nm, which are usually used in the art, can be provided by adding a sensitizing dye having maximum absorption at 300 to 450 nm, a sensitizing dye having maximum absorption at 500 to 600 nm, and an infrared absorbent having maximum absorption at 750 to 1,400 nm, respectively.

First, the sensitizing dye having maximum absorption in a wavelength region of 350 to 450 nm is described. Examples of such a sensitizing dye include merocyanine dyes, benzopyranes, coumarins, aromatic ketones and anthracenes.

Out of sensitizing dyes having absorption maximum in the wavelength region of 360 to 450 nm, in view of high sensitivity, the dye is preferably a dye represented by the following formula (IX):

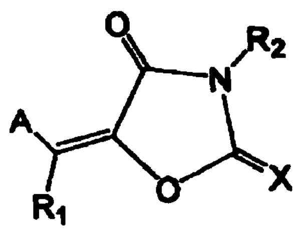

(IX)

(In formula (IX), A represents an aromatic ring or heterocyclic group which may have a substituent, X represents an oxygen atom, a sulfur atom or N-($R_3$), $R_1$, $R_2$ and $R_3$ each independently represents a monovalent nonmetallic atom group, the pairs of A and $R_1$ and of $R_2$ and $R_3$ each may combine together to form an aliphatic or aromatic ring.)

Formula (IX) is described in more detail. $R_1$, $R_2$ and $R_3$ each is independently a monovalent nonmetallic atom group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxyl group or a halogen atom.

Next, A in formula (IX) is described. A represents an aromatic ring or heterocyclic group which may have a substituent, and specific examples of the aromatic ring or heterocyclic ring which may have a substituent are the same as those described for $R_1$, $R_2$ and $R_3$ in formula (IX).

As for specific examples of such a sensitizing dye, compounds described in paragraphs [0047] to [0053] of JP-A-2007-58170 may be preferably used.

Sensitizing dyes represented by the following formulae (V) to (VII) may also be used.

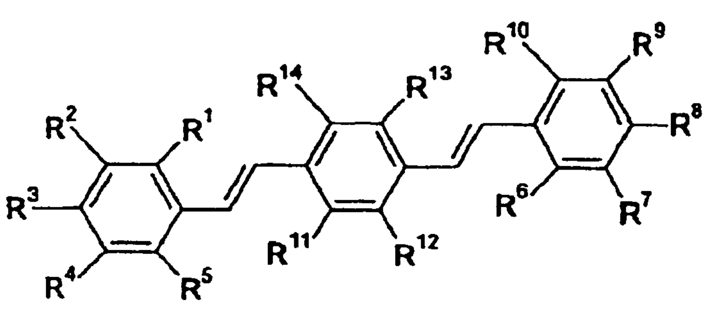

(V)

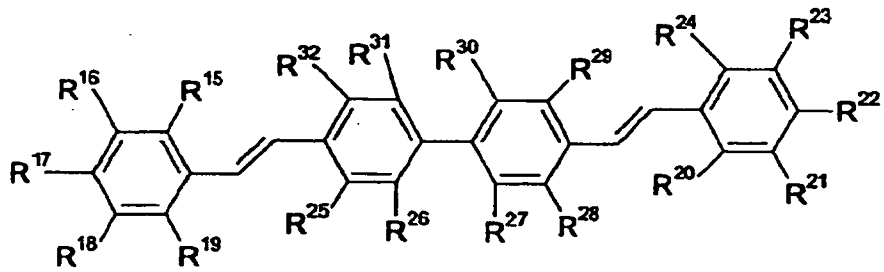

(VI)

In formula (V), $R^1$ to $R^{14}$ each independently represents a hydrogen atom, an alkyl group, an alkoxy group, a cyano group or a halogen atom, provided that at least one of $R^1$ to $R^{10}$ represents an alkoxy group having a carbon number of 2 or more.

In formula (VI), $R^{15}$ to $R^{32}$ each independently represents a hydrogen atom, an alkyl group, an alkoxy group, a cyano group or a halogen atom, provided that at least one of $R^{15}$ to $R^{24}$ represents an alkoxy group having a carbon number of 2 or more.

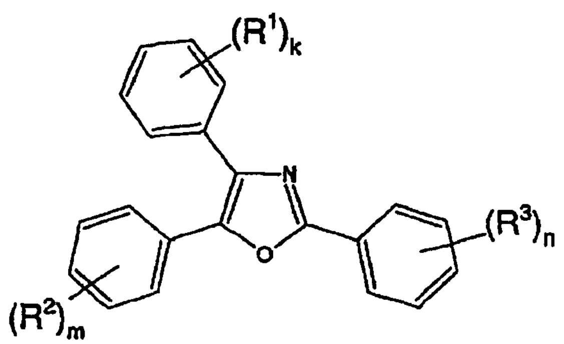

(VII)

In formula (VII), $R^1$, $R^2$ and $R^3$ each independently represents a halogen atom, an alkyl group, an aryl group, an aralkyl group, a $-NR^4R^5$ group or a $-OR^6$ group, $R^4$, $R^5$ and $R^6$ each independently represents a hydrogen atom, an alkyl group, an aryl group or an aralkyl group, and k, m and n each independently represents an integer of 0 to 5.

Furthermore, sensitizing dyes described in JP-A-2007-171406, JP-A-2007-206216, JP-A-2007-206217, JP-A-2007-225701, JP-A-2007-225702, JP-A-2007-316582 and JP-A-2007-328243 may also be preferably used.

The amount of the sensitizing dye added is preferably from 0.05 to 30 parts y mass, more preferably from 0.1 to 20 parts by mass, and most preferably from 0.2 to 10 parts by mass, per 100 parts by mass of all solid contents in the photosensitive layer.

The sensitizing dye having maximum absorption at 750 to 1,400 nm, which is suitably used in the present invention, is described in detail below.

It is presumed that the sensitizing dye used here creates an electron-excited state with high sensitivity to irradiation (exposure) of an infrared laser and, for example, electron transfer, energy transfer or heat generation (light-to-heat converting function) promoted in this electron-excited state acts on the polymerization initiator present together in the photosensitive layer to cause the polymerization initiator to undergo chemical change and generate a radical. In any case, addition of a sensitizing dye having maximum absorption at 750 to 1,400 nm is suitable particularly for plate-making of directly drawing an image by infrared laser light having a wavelength of 750 to 1,400 nm, and high image formability can be brought out as compared with conventional lithographic printing plate precursors.

The infrared absorbent is preferably a dye or pigment having absorption maximum at a wavelength of 750 to 1,400 nm.

As for the dye, commercially available dyes and known dyes described in publications such as Senryo Binran (Handbook of Dyes), compiled by The Synthetic Organic Chemistry, Japan (1970), may be used. Specific examples thereof include a dye such as azo dye, metal complex salt azo dye, pyrazolone azo dye, naphthoquinone dye, anthraquinone dye, phthalocyanine dye, carbonium dye, quinoneimine dye, methine dye, cyanine dye, squarylium dye, pyrylium salt and metal thiolate complex.

Among these dyes, preferred are a cyanine dye, a squarylium dye, a pyrylium salt, a nickel thiolate complex

and an indolenine cyanine dye, more preferred are a cyanine dye and an indolenine cyanine dye, still more preferred is, for example, a cyanine dye represented by the following formula (a):

Formula (a):

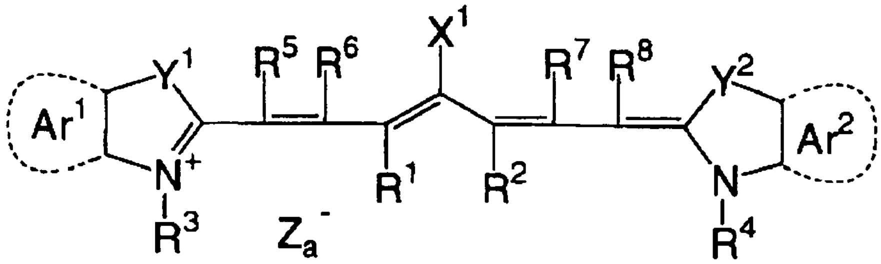

In formula (a), $X^1$ represents a hydrogen atom, a halogen atom, $-NPh_2$, $X^2$-$L^1$ or a group shown below, wherein $X^2$ represents an oxygen atom, a nitrogen atom or a sulfur atom, and $L^1$ represents a hydrocarbon group having a carbon number of 1 to 12, an aromatic ring having a heteroatom, or a hydrocarbon group having a carbon number of 1 to 12 and containing a heteroatom. Incidentally, the heteroatom as used here indicates N, S, O, a halogen atom or Se. $X_a^-$ has the same definition as $Za^-$ described later. $R^a$ represents a substituent selected from a hydrogen atom, an alkyl group, an aryl group, a substituted or unsubstituted amino group and a halogen atom.

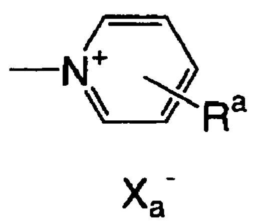

$R^1$ and $R^2$ each independently represents a hydrocarbon group having a carbon number of 1 to 12. In view of storage stability of the coating solution for photosensitive layer, $R^1$ and $R^2$ each is preferably a hydrocarbon group having a carbon number of 2 or more. It is more preferred that $R^1$ and $R^2$ combine together to form a 5-or 6-membered ring.

$Ar^1$ and $Ar^2$ may be the same or different and each represents an aromatic hydrocarbon group which may have a substituent. Preferred examples of the aromatic hydrocarbon group include a benzene ring and a naphthalene ring. Preferred examples of the substituent include a hydrocarbon group having a carbon number of 12 or less, a halogen atom and an alkoxy group having a carbon number of 12 or less. $Y^1$ and $Y^2$ may be the same or different and each represents a sulfur atom or a dialkylmethylene group having a carbon number of 12 or less. $R^3$ and $R^4$ may be the same or different and each represents a hydrocarbon group having a carbon number of 20 or less, which may have a substituent. Preferred examples of the substituent include an alkoxy group having a carbon number of 12 or less, a carboxyl group and a sulfo group. $R^5$, $R^6$, $R^7$ and $R^8$, which may be the same or different, each represents a hydrogen atom or a hydrocarbon group having a carbon number of 12 or less and in view of availability of the raw material, is preferably a hydrogen atom. $Za^-$ represents a counter anion, but when the cyanine dye represented by formula (a) has an anionic substituent in its structure and neutralization of electric charge is not necessary, $Za^-$ is not present. In view of storage stability of the coating solution for photosensitive layer, $Za^-$ is preferably halogen ion, perchlorate ion, tetrafluoroborate ion, hexafluorophosphate ion or sulfonate ion, more preferably perchlorate ion, hexafluorophosphate ion or arylsulfonate ion. Incidentally, it is particularly preferred not to contain halogen ion as the counter ion.

Specific examples of the cyanine dye represented by formula (a) which can be suitably used include those described in paragraphs [0017] to [0019] of JP-A-2001-133969.

Other particularly preferred examples include specific indolenine cyanine dyes described in JP-A-2002-278057 *supra*.

As for the pigment, commercially available pigments and pigments described in Color Index (C.I.) Binran (C.I. Handbook), Saishin Ganryo Binran (Handbook of Latest Pigments), compiled by Nippon Ganryo Gijutsu Kyokai (1977), Saishin Ganryo Oyo Gijutsu (Latest Pigment Application Technology), CMC Shuppan (1986), and Insatsu Ink Gijutsu (Printing Ink Technology), CMC Shuppan (1984) can be used.

The kind of the pigment includes black pigment, yellow pigment, orange pigment, brown pigment, red pigment, violet pigment, blue pigment, green pigment, fluorescent pigment, metal powder pigment and polymer-bound dye. Specific examples of the pigment which can be used include an insoluble azo pigment, an azo lake pigment, a condensed azo pigment, a chelate azo pigment, a phthalocyanine-based pigment, an anthraquinone-based pigment, a perylene- or perynone-based pigment, a thioindigo-based pigment, a quinacridone-based pigment, a dioxazine-based pigment, an isoindolinone-based pigment, a quinophthalone-based pigment, a dyed lake pigment, an azine pigment, a nitroso pigment, a nitro pigment, a natural pigment, a fluorescent pigment, an inorganic pigment and carbon black. Among these pigments, carbon black is preferred.

These pigments may or may not be surface-treated before use. Examples of the method for surface treatment include a method of coating the surface with resin or wax, a method of attaching a surfactant, and a method of bonding a reactive substance (for example, a silane coupling agent, an epoxy compound or an isocyanate) to the pigment surface. These surface-treating methods are described in Kinzoku Sekken no Seishitsu to Oyo (Properties and Application of Metal Soap), Saiwai Shobo, Insatsu Ink Gijutsu (Printing Ink Technology), CMC Shuppan (1984), and Saishin Ganryo Oyo Gijutsu (Latest Pigment Application Technology), CMC Shuppan (1986).

The particle diameter of the pigment is preferably from 0.01 to 10 $\mu$m, more preferably from 0.05 to 1 $\mu$m, still more preferably from 0.1 to 1 $\mu$m. Within this preferred range, excellent dispersion stability of the pigment in the photosensitive layer and a uniform photosensitive layer can be obtained.

As for the method of dispersing the pigment, a known dispersion technique employed in the production of ink, toner or the like may be used. Examples of the dispersing machine include an ultrasonic disperser, a sand mill, an attritor, a pearl mill, a super-mill, a ball mill, an impeller, a disperser, a KD mill, a colloid mill, a dynatron, a three-roll mill and a pressure kneader. These are described in detail in Saishin Ganryo Oyo Gijutsu (Latest Pigment Application Technology), CMC Shuppan (1986).

The infrared absorbent may be added together with other components in the same layer or may be added to a layer provided separately.

In view of uniformity in the photosensitive layer or durability of the photosensitive layer, the infrared absorbent is preferably added in a ratio of 0.01 to 50 mass%, preferably from 0.1 to 10 mass%, and in the case of a dye, more preferably from 0.5 to 10 mass% or in the case of a pigment, more preferably from 0.1 to 10 mass%, based on all solid contents constituting the photosensitive layer,

<Other Components of Image Forming Layer>

The image forming layer for use in the present invention may further contain various additives, if desired. Examples of the additive which can be added include a surfactant for promoting the developability and enhancing the coated surface state, a hydrophilic polymer for enhancing the developability or the dispersion stability of microcapsule, a colorant or printing-out agent for distinguishing the image part and the non-image part with an eye, a polymerization inhibitor for preventing unnecessary thermal polymerization of the radical polymerizable compound during production or storage of the image forming layer, a higher fatty acid derivative for preventing the polymerization inhibition by oxygen, an inorganic fine particle for enhancing the strength of cured film in the image part, a hydrophilic low-molecular compound for enhancing the developability, a co-sensitizer or chain transfer agent for raising the sensitivity, and a plasticizer for enhancing the plasticity. For all of these additives, a known compound can be used and, for example, compounds described in JP-A-2007-171406, JP-A-2007-206216, JP-A-2007-206217, JP-A-2007-225701, JP-A-2007-225702, JP-A-2007-316582 and JP-A-2007-328243 may be used.

As regards the compound acting as a chain transfer agent, for example, compounds containing SH, PH, SiH or GeH in the molecule may be used. Such a compound can donate hydrogen to a low-activity radical species to produce a radical or can be oxidized and then deprotonated to produce a radical.

In the image forming layer of the present invention, a thiol compound (for example, 2-mercaptobenzimidazoles, 2-mercaptobenzothiazoles, 2-mercaptobenzoxazoles, 3-mercaptotriazoles or 5-mercaptotetrazoles) may be preferably used as the chain transfer agent.

Above all, a thiol compound represented by the following formula (I) is suitably used in particular. By using this thiol compound as the chain transfer agent, the problem of odor or the reduction in sensitivity due to evaporation from the image forming layer or diffusion into other layers can be avoided, and a lithographic printing plate precursor excellent in the storage stability and assured of high sensitivity and high press life can be obtained.

Formula (I):

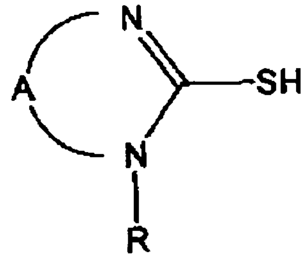

In formula (I), R represents an alkyl group which may have a substituent, or an aryl group which may have a substituent; and A represents an atomic group necessary for forming a carbon atom-containing 5-membered or 6-membered heterocyclic ring together with the N=C-N moiety, and A may have a substituent.

More preferably, a compound represented by the following formula (IA) or (IB) is used.

Formula (IA):

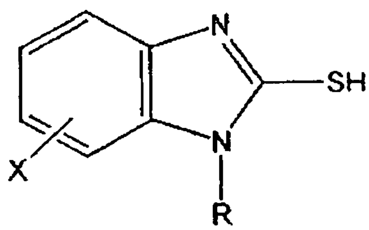

Formula (IB):

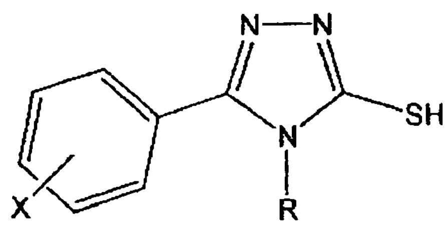

In formulae (IA) and (IB), R represents an alkyl group which may have a substituent, or an aryl group which may have a substituent; and X represents a halogen atom, an alkoxyl group, an alkyl group which may have a substituent, or an aryl group which may have a substituent.

Specific examples of the compound represented by formula (I) are set forth below, but the present invention is not limited thereto.

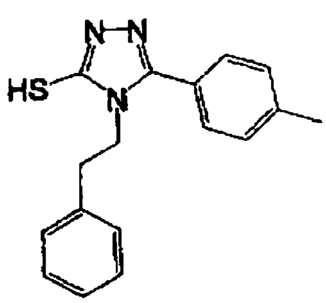

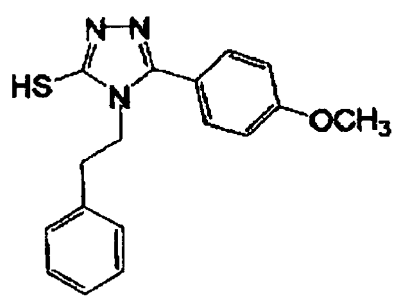

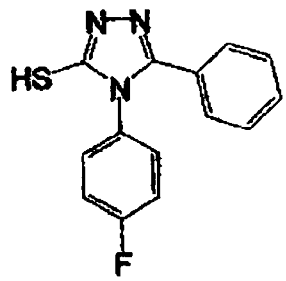

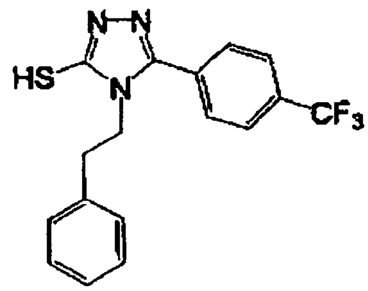

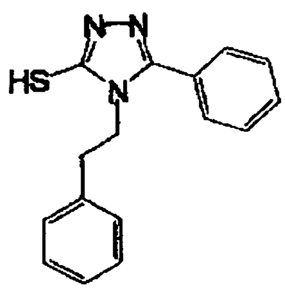

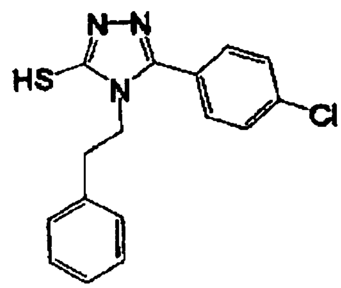

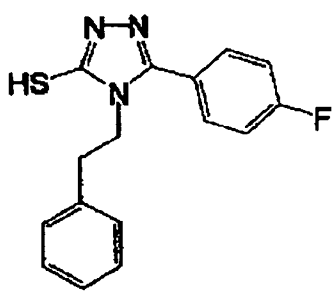

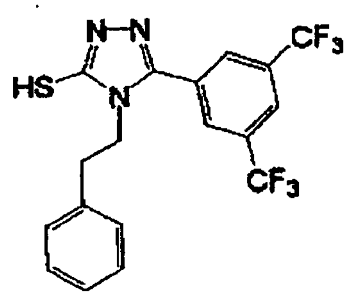

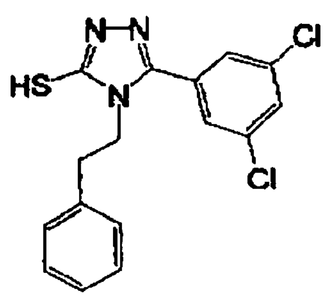

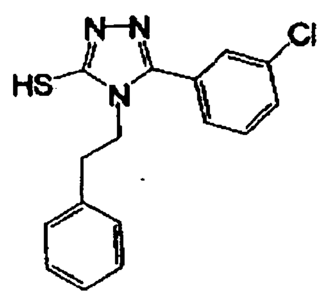

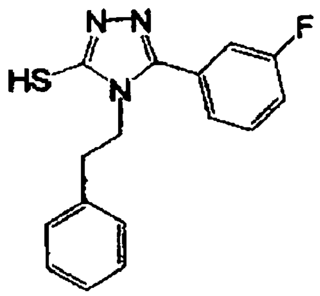

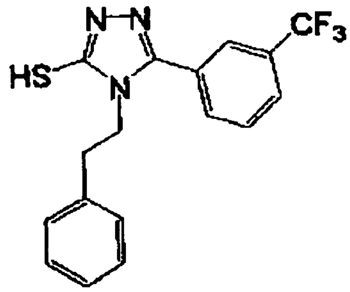

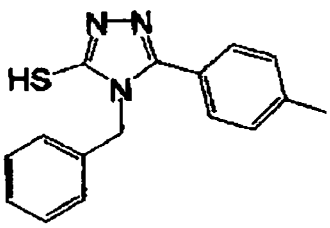

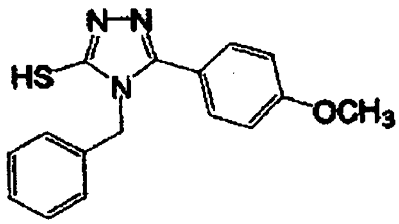

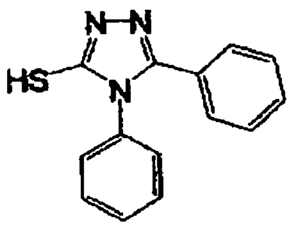

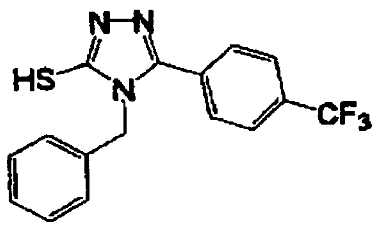

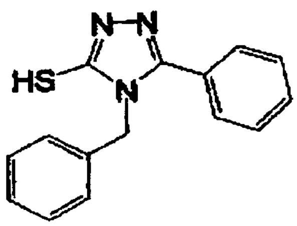

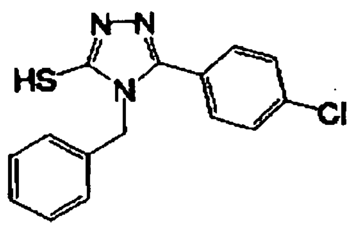

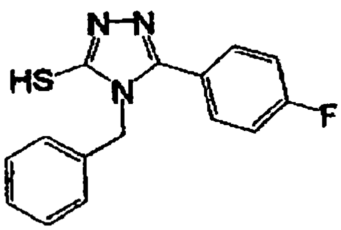

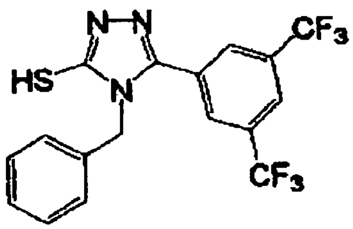

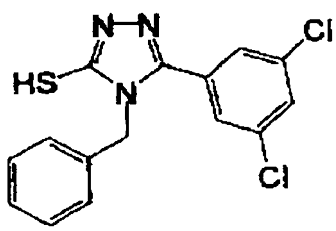

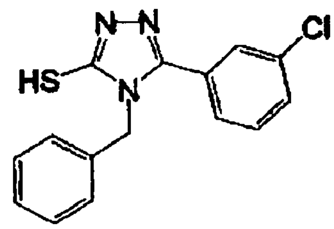

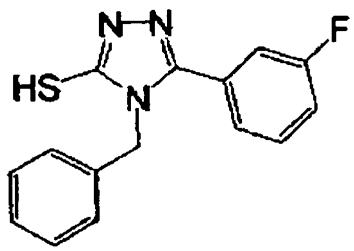

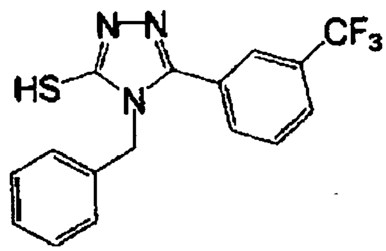

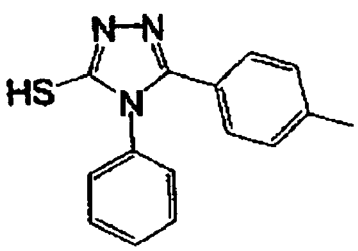

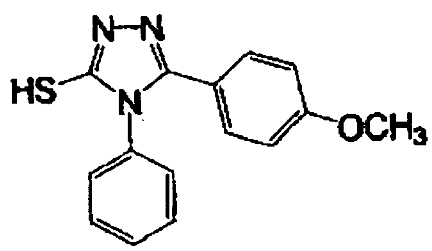

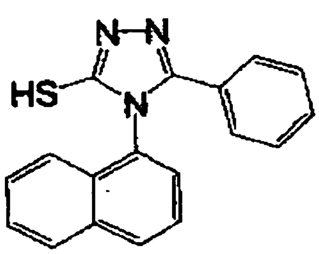

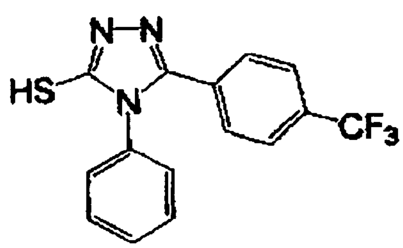

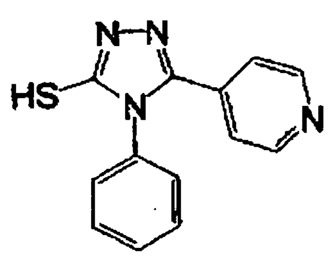

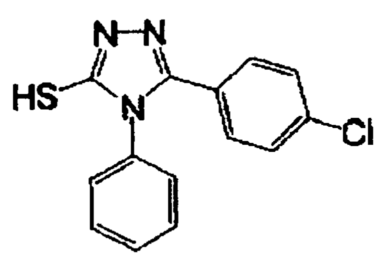

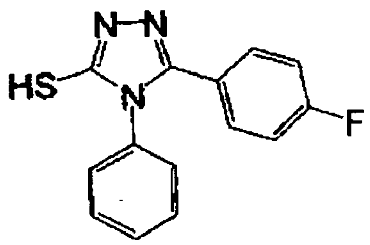

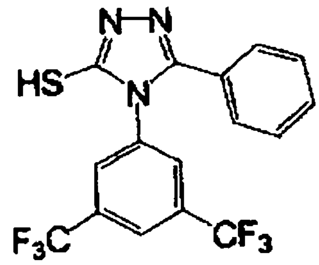

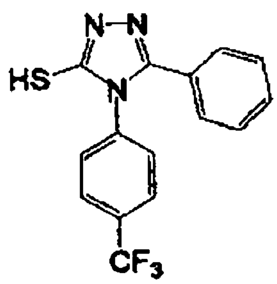

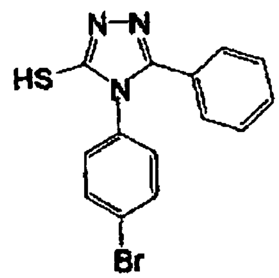

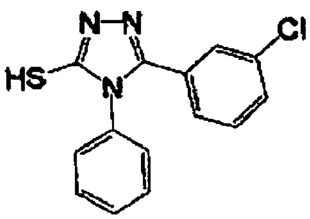

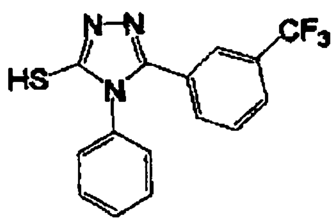

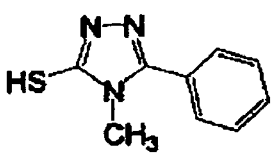

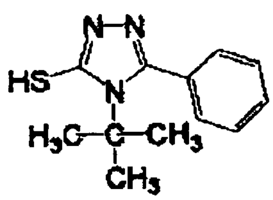

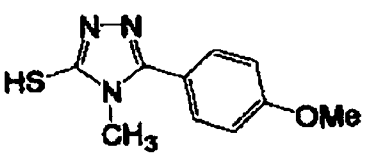

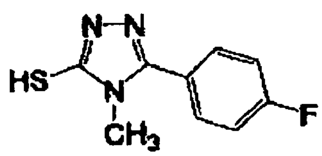

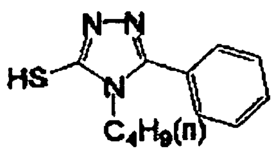

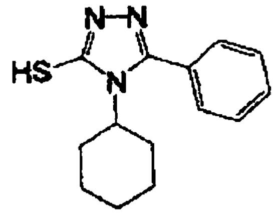

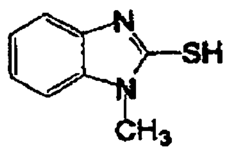

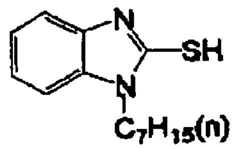

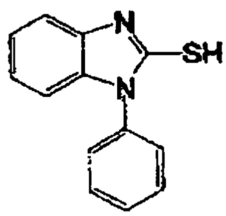

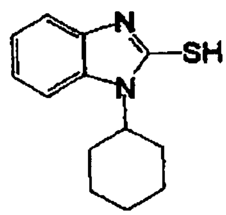

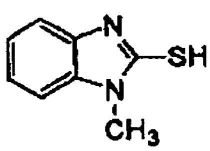

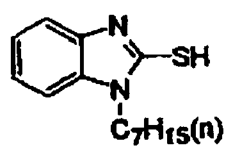

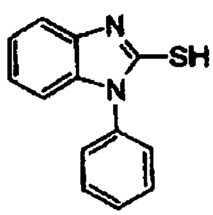

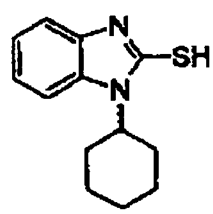

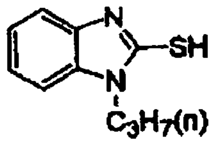

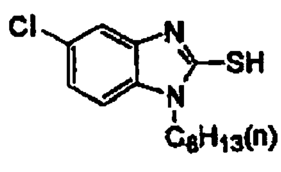

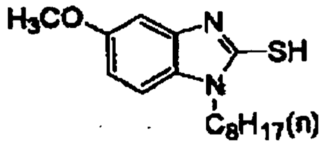
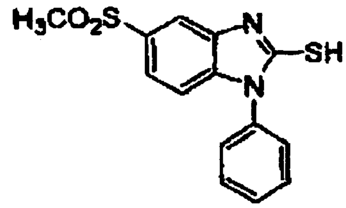
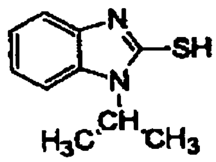
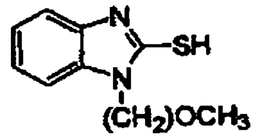
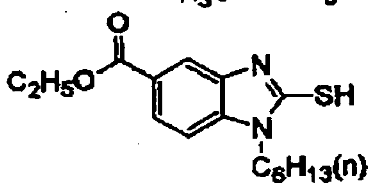
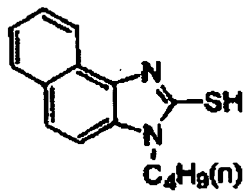
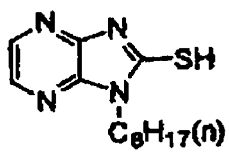
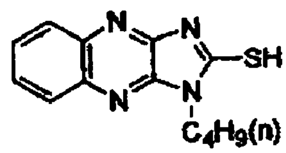
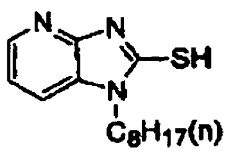
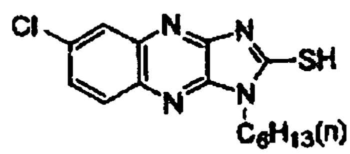
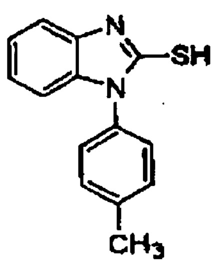
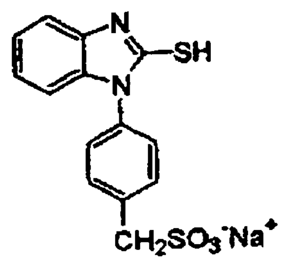

The amount of the thiol compound used is preferably from 0.01 to 20 mass%, more preferably from 0.1 to 15 mass%, still more preferably from 1.0 to 10 mass%, based on the mass of all solid contents in the photosensitive layer.

<Microcapsule>

In the present invention, as for the method of incorporating the above-described constituent components of the image forming layer and other constituent components described later into the image forming layer, for example, a part of the constituent components may be microencapsulated and added to the image forming layer as described in JP-A-2001-277740 and JP-A-2001-277742. In this case, each constituent component may be contained inside and outside the microcapsule in an arbitrary ratio.

For microencapsulating the constituent component of the image forming layer, a known method may be applied. Examples of the production method of a microcapsule include, but are not limited to, a method utilizing coacervation described in U.S. Patents 2,800,457 and 2,800,458, a method by interfacial polymerization described in U.S. Patent 3,287,154, JP-B-38-19574 and JP-B-42-446, a method by polymer precipitation described in U.S. Patents 3,418,250 and 3,660,304, a method using an isocyanate polyol wall material described in U.S. Patent 3,796,669, a method using an isocyanate wall material described in U.S. Patent 3,914,511, a method using a urea-formaldehyde or urea-formaldehyde-resorcinol wall-forming material described in U.S. Patents 4,001,140, 4,087,376 and 4,089,802, a method using a wall material such as melamine-formaldehyde resin or hydroxy cellulose described in U.S. Patent 4,025,445, an *in situ* method by monomer polymerization described in JP-B-36-9163 and JP-A-51-9079, a spray drying method described in British Patent 930,422 and U.S. Patent 3,111,407, and an electrolytic dispersion cooling method described in British Patents 952,807 and 967,074.

The microcapsule wall for use in the present invention preferably has a three-dimensionally crosslinked structure and has a property of swelling with a solvent. From this standpoint, the microcapsule wall material is preferably polyurea, polyurethane, polyester, polycarbonate, polyamide or a mixture thereof, more preferably polyurea or polyurethane. Also, the above-described compound having a crosslinking functional group such as ethylenically unsaturated bond, which can be introduced into the non-aqueous polymer, may be introduced into the microcapsule wall.

The average particle diameter of the microcapsule is preferably from 0.01 to 3.0 μm, more preferably from 0.05 to 2.0 μm, still more preferably from 0.10 to 1.0 μm. Within this range, good resolution and good aging stability can be obtained.

(Formation of Image Forming Layer)

For the formation of the image forming layer, several embodiments can be employed. One embodiment is a method of dissolving the constituent components of the image forming layer in an appropriate solvent and coating the solution on a support as described, for example, in JP-A-2002-287334. Examples of the solvent used here include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone, toluene and water. These solvents may be used as a single solvent or as a mixture of solvents. Another embodiment is a method of microencapsulating the constituent component of the image forming layer and incorporating the microcapsule into the image forming layer (microcapsule-type image forming layer) as described, for example, in JP-A-2001-277740 and JP-A-2001-277742. In the microcapsule-type image forming layer, the constituent component may be contained also outside of the microcapsule. As regards the microcapsule-type image forming layer, it is a more preferred embodiment that the hydrophobic constituent component is microencapsulated and the hydrophilic constituent component is contained outside of the microcapsule.

For microencapsulating the constituent component of the image forming layer, a known method can be applied. Examples of the production method of a microcapsule include a method utilizing coacervation described in U.S. Patents 2,800,457 and 2,800,458, a method by interfacial polymerization described in U.S. Patent 3,287,154, JP-B-38-19574 and JP-B-42-446, a method by polymer precipitation described in U.S. Patents 3,418,250 and 3,660,304, a method using an isocyanate polyol wall material described in U.S. Patent 3,796,669, a method using an isocyanate wall material described in U.S. Patent 3,914,511, a method using a urea-formaldehyde or urea-formaldehyde-resorcinol wall-forming material described in U.S. Patents 4,001,140, 4,087,376 and 4,089,802, a method using a wall material such as melamine-formaldehyde resin or hydroxy cellulose described in U.S. Patent 4,025,445, an *in situ* method by monomer polymerization described in JP-B-36-9163 and JP-A-51-9079, a spray drying method described in British Patent 930,422 and U.S. Patent 3,111,407, and an electrolytic dispersion cooling method described in British Patents 952,807 and 967,074.

The microcapsule wall for use in the present invention preferably has a three-dimensionally crosslinked structure and a property of swelling with a solvent. From this standpoint, the microcapsule wall material is preferably polyurea, polyurethane, polyester, polycarbonate, polyamide or a mixture thereof, more preferably polyurea or polyurethane. Also, a compound having a crosslinking functional group such as ethylenically unsaturated bond may be introduced into the microcapsule wall.

In view of good resolution and good aging stability, the average particle diameter of the microcapsule is preferably from 0.01 to 3.0 μm, more preferably from 0.05 to 2.0 μm, still more preferably from 0.10 to 1.0 μm.

In the present invention, an embodiment of incorporating the above-described constituent component of the image forming layer, preferably an infrared absorbent in particular, into a resin fine particle may also be employed.

Such an embodiment is achieved using a resin fine particle liquid dispersion prepared by dissolving the constituent component in a solvent and mixing the resulting solution with a polymer solution (preferably an aqueous polymer solution) by means of a homogenizer or the like.

Examples of the solvent which can be used here include ethyl acetate, methyl ethyl ketone (MEK), diisopropyl

ether, dichloromethane, chloroform, toluene, dichloroethane, and a mixed solvent thereof. The solvent is used as a single solvent or a mixture of solvents.

Examples of the polymer include polyvinyl alcohol (PVA), polyacrylic acid, sodium polyacrylate, polyacrylamide, polymethacrylic acid, sodium polymethacrylate, polymethacrylamide, polystyrenesulfonic acid, sodium polystyrenesulfonate, an acrylic acid-methyl acrylate copolymer, a methacrylic acid-methyl methacrylate copolymer, and a styrene-sodium styrenesulfonate copolymer.

The solid content concentration of the coating solution for image forming layer is preferably from 1 to 50 mass%.

The image forming layer may also be formed by dispersing or dissolving the same or different components in the same or different solvents to prepare a plurality of coating solutions and repeating the coating and drying a plurality of times.

The coated amount (as solid content) of the image forming layer varies according to the usage, but in consideration of good sensitivity, good film property and the like, the coated amount in general is preferably from 0.3 to 3.0 g/$m^2$.

For the coating of the image forming layer, various methods may be used. Examples thereof include bar coater coating, spin coating, spray coating, curtain coating, dip coating, air knife coating, blade coating and roll coating.

The image forming layer coated on a support by the method above is dried for removing the solvent used. Examples of the drying method include a method of blowing hot air on the coated surface, and a method of placing the support in a heated oven for a fixed time.

For producing a lithographic printing plate precursor used in the plate-making method of the present invention, the temperature on the support surface at the drying above is preferably kept at a temperature not more than the thermal fusion bonding temperature of the thermal fusion bonding resin fine particle contained in the image forming layer, more preferably at a temperature 5˚C lower than the thermal fusion bonding temperature. By keeping the drying temperature in this range, the thermal fusion bonding resin fine particle contained in the image forming layer can be caused to remain still in the fine particle form in the image forming layer.

(Support)

The support for use in the lithographic printing plate precursor of the present invention is not particularly limited and may be sufficient if it is a dimensionally stable plate-like hydrophilic support. Examples thereof include paper, paper laminated with plastic (e.g., polyethylene, polypropylene, polystyrene), metal plate (e.g., aluminum, zinc, copper), plastic film (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal), and paper or plastic film laminated or vapor-deposited with the metal above. Among these supports, a polyester film and an aluminum plate are preferred, and an aluminum plate is more preferred because this is dimensionally stable and relatively inexpensive.

The aluminum plate includes a pure aluminum plate, an alloy plate mainly comprising aluminum and containing trace heteroelements, and an aluminum or aluminum alloy thin film laminated with a plastic. Examples of the heteroelement contained in the aluminum alloy include silicon, iron, manganese, copper, magnesium, chromium, zinc, bismuth, nickel and titanium. The heteroelement content in the alloy is preferably 10 mass% or less. Since perfectly pure aluminum is difficult to produce in view of refining technique, an alloy plate containing trace heteroelements may be suitably used. The aluminum plate is not limited in its composition, and a conventionally known and commonly employed material can be appropriately used. The thickness of the aluminum plate is preferably from 0.1 to 0.6 mm, more preferably from 0.15 to 0.4 mm, still more preferably from 0.2 to 0.3 mm.

The aluminum plate is preferably subjected to a surface treatment such as surface roughening and anodization. This surface treatment facilitates enhancing hydrophilicity and ensuring adherence to the image forming layer. In advance of the surface-roughening treatment of the aluminum plate, a degreasing treatment with a surfactant, an organic solvent, an alkaline aqueous solution or the like is performed, if desired, for removing the rolling oil on the surface.

The surface-roughening treatment of the aluminum plate surface is performed by various methods, and examples thereof include a mechanical surface-roughening treatment, an electrochemical surface-roughening treatment (a surface-roughening treatment of electrochemically dissolving the surface) and a chemical surface-roughening treatment (a surface-roughening treatment of chemically and selectively dissolving the surface). Examples of the method for the mechanical surface-roughening treatment include ball polishing, brush polishing, blast polishing and buff polishing. Examples of the method for the electrochemical surface-roughening treatment include a method of performing the treatment by passing an alternating or direct current in an electrolytic solution containing an acid such as hydrochloric acid or nitric acid. Also, a method using a mixed acid described in JP-A-54-63902 may be used.

The surface-roughened aluminum plate is, if desired, subjected to an alkali etching treatment using an aqueous solution of potassium hydroxide, sodium hydroxide or the like and after a neutralization treatment, further subjected to an anodization treatment, if desired, so as to enhance the abrasion resistance.

In the anodization treatment of the aluminum plate, various electrolytes for forming a porous oxide film may

be used. In general, a sulfuric acid, a hydrochloric acid, an oxalic acid, a chromic acid or a mixed acid thereof is used. The electrolyte concentration is appropriately determined according to the kind of the electrolyte.

The anodization treatment conditions vary depending on the electrolyte used and cannot be indiscriminately specified, but in general, the conditions are preferably such that the electrolyte concentration is from 1 to 80 mass%, the liquid temperature is from 5 to 70°C, the current density is from 5 to 60 A/dm$^2$, the voltage is from 1 to 100 V, and the electrolysis time is from 10 seconds to 5 minutes. The amount of the anodic oxide film formed is, in view of good press life and good scratch resistance of the non-image part, preferably from 1.0 to 5.0 g/m$^2$, more preferably from 1.5 to 4.0 g/m$^2$.

As for the support, the substrate having thereon an anodic oxide film after the above-described surface treatment may be directly used, but in order to more improve adherence to the upper layer, hydrophilicity, difficult staining, heat insulation and the like, known treatments such as treatment for enlarging micropores of the anodic oxide film, treatment for sealing micropores, and treatment for making the surface hydrophilic by dipping the substrate in an aqueous solution containing a hydrophilic compound, described in JP-A-2001-253181 and JP-A-2001-322365, may be appropriately selected and performed.

Examples of the pore-sealing treatment include a pore-sealing treatment with water vapor, a treatment with fluorozirconic acid alone, a pore-sealing treatment with an aqueous solution containing an inorganic fluorine compound, such as treatment with sodium fluoride, a pore-sealing treatment with steam having added thereto lithium chloride, and a pore-sealing treatment with hot water. Among these, a pore-sealing treatment with an aqueous solution containing an inorganic fluorine compound, a pore-sealing treatment with water vapor, and a pore-sealing treatment with hot water are preferred.

The hydrophilic treatment includes an alkali metal silicate method described in U.S. Patents 2,714,066, 3,181,461, 3,280,734 and 3,902,734. In this method, the support is subjected to a dipping or electrolysis treatment in an aqueous solution of sodium silicate or the like. Other examples include a method of treating the support with potassium fluorozirconate described in JP-B-36-22063, and a method of treating the support with a polyvinylphosphonic acid described in U.S. Patents 3,276,868, 4,153,461 and 4,689,272.

In the case where a support insufficient in the hydrophilicity on the surface, such as polyester film, is used as the support, a hydrophilic layer is preferably coated to make the surface hydrophilic. The hydrophilic layer is preferably a hydrophilic layer formed by applying a coating solution containing a colloid of an oxide or hydroxide of at least one element selected from beryllium, magnesium, aluminum, silicon, titanium, boron, germanium, tin, zirconium, iron, vanadium, antimony and a transition metal described in JP-A-2001-199175, a hydrophilic layer having an organic hydrophilic matrix obtained by crosslinking or pseudo-crosslinking an organic hydrophilic polymer described in JP-A-2002-79772, a hydrophilic layer having an inorganic hydrophilic matrix obtained by sol-gel conversion comprising hydrolysis and condensation reaction of polyalkoxysilane, titanate, zirconate or aluminate, or a hydrophilic layer composed of an inorganic thin film having a metal oxide-containing surface. Among these, a hydrophilic layer formed by applying a coating solution containing a colloid of silicon oxide or hydroxide is more preferred.

In the case of using a polyester film or the like as the support, an antistatic layer is preferably provided on the hydrophilic layer side or opposite side of the support or on both sides. When an antistatic layer is provided between the support and the hydrophilic layer, this contributes also to the enhancement of adherence to the hydrophilic layer. Examples of the antistatic layer which can be used include a polymer layer having dispersed therein a metal oxide fine particle or a matting agent described in JP-A-2002-79772.

In view of good adherence to image forming layer, good press life, good difficulty of staining and the like, the centerline average roughness of the support is preferably from 0.10 to 1.2 μm. Also, for example, in view of good image-forming property by virtue of antihalation at the image exposure and good suitability for plate inspection after development, the color density of the support is preferably from 0.15 to 0.65 in terms of the reflection density value.

(Undercoat Layer)

In the lithographic printing plate precursor according to the present invention, an undercoat layer may be provided between the image forming layer and the support, if desired. The undercoat layer has a function of strengthening adherence between the support and the image recording layer in the exposed area and a function of facilitating the separation of image recording layer from the support in the unexposed area, and therefore, the developability is enhanced.

Specific suitable examples of the undercoat layer include a silane coupling agent having an addition-polymerizable ethylenic double bond reactive group described in JP-A-10-282679, and a phosphorus compound having an ethylenic double bond reactive group described in JP-A-2-304441.

A known resin having a hydrophilic group may also be used for the undercoat layer. Specific examples of such a resin include gum arabic, casein, gelatin, a starch derivative, carboxymethyl cellulose and a sodium salt thereof, cellulose acetate, sodium alginate, vinyl acetate-maleic acid copolymers, styrene-maleic acid copolymers, polyacrylic acids and salts thereof, polymethacrylic acids and salts thereof, a homopolymer or copolymer of hydroxyethyl methacrylate, a homopolymer or copolymer of hydroxyethyl acrylate, a homopolymer or copolymer of hydroxypropyl methacrylate, a homopolymer or copolymer of hydroxypropyl acrylate, a homopolymer or copolymer of hydroxybutyl methacrylate, a homopolymer or copolymer of hydroxybutyl acrylate, polyethylene glycols, hydroxypropylene polymers, polyvinyl alcohols, a hydrolyzed polyvinyl acetate having a hydrolysis degree of 60 mol% or more, preferably 80 mol% or more, polyvinyl formal, polyvinyl butyral, polyvinylpyrrolidone, a homopolymer or copolymer of acrylamide, a homopolymer or copolymer of methacrylamide, a homopolymer or copolymer of N-methylolacrylamide, polyvinylpyrrolidone, an alcohol-soluble nylon, and a polyether of 2,2-bis-(4-hydroxyphenyl)-propane with epichlorohydrin.

The polymer compound for use in the undercoat layer preferably has adsorptivity to the support surface. The presence or absence of adsorptivity to the support surface can be judged, for example, by the following method.

A test compound is dissolved in a solvent capable of easily dissolving the compound to prepare a coating solution, and the coating solution is coated and dried on a support such that the coated amount after drying becomes 30 $mg/m^2$. Thereafter, the support coated with the test compound is thoroughly washed with a solvent capable of easily dissolving the compound and after measuring the residual amount of the test compound that is not removed by washing, the amount adsorbed to the support is calculated. Here, in the measurement of the residual amount, the amount of the residual compound may be directly determined or the residual amount may be calculated after quantitatively determining the test compound dissolved in the washing solution. The quantitative determination of the compound may be performed, for example, by fluorescent X-ray measurement, reflection spectral absorbance measurement or liquid chromatography measurement. The compound having adsorptivity to the support is a compound which remains in an amount of 1 $mg/m^2$ or more even when the above-described washing treatment is performed.

Adsorptivity to the support surface can be imparted to the polymer compound by introducing an adsorptive group. The adsorptive group to the support surface is a functional group capable of causing chemical bonding (for example, ionic bonding, hydrogen bonding, coordination bonding, or bonding by intermolecular force) with a substance (e.g., metal, metal oxide) or functional group (e.g., hydroxyl group) present on the support surface. The adsorptive group is preferably an acid group or a cationic group.

The acid group preferably has an acid dissociation constant (pKa) of 7 or less. Examples of the acid group include a phenolic hydroxyl group, a carboxyl group, $-SO_3H$, $-OSO_3H$, $-PO_3H_2$, $-OPO_3H_2$, $-CONHSO_2-$, $-SO_2NHSO_2-$ and $-COCH_2COCH_3$. Above all, a phosphoric acid group ($-OPO_3H_2$, $-PO_3H_2$) is preferred. Also, these acid groups may be in the form of a metal salt.

The cationic group is preferably an onium group. Examples of the onium group include an ammonium group, a phosphonium group, an arsonium group, a stibonium group, an oxonium group, a sulfonium group, a selenonium group, a stannonium group and an iodonium group. Among these, an ammonium group, a phosphonium group and a sulfonium group are preferred, an ammonium group and a phosphonium group are more preferred, and an ammonium group is most preferred.

For introducing an adsorptive group into the polymer compound, a monomer having an adsorptive group is used. Preferred examples of the monomer having an adsorptive group include compounds represented by the following formulae (VII) and (VIII).

( VII )

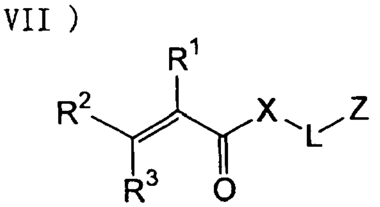

( VIII )

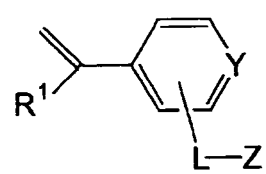

In formulae (VII) and (VIII), $R^1$, $R^2$ and $R^3$ each independently represents a hydrogen atom, a halogen atom or an alkyl group having a carbon number of 1 to 6. $R^1$, $R^2$ and $R^3$ each is independently preferably a hydrogen atom or an alkyl group having a carbon number of 1 to 6, more preferably a hydrogen atom or an alkyl group having a carbon number of 1 to 3, and most preferably a hydrogen atom or a methyl group. In particular, $R^2$ and $R^3$ each is preferably a hydrogen atom.

X is an oxygen atom (-O-) or an imino (-NH-). X is preferably an oxygen atom.

L is a divalent linking group. L is preferably a divalent aliphatic group (e.g., alkylene, alkenylene, alkynylene), a divalent aromatic group (e.g., arylene), a divalent heterocyclic group, or a combination of such a group with an oxygen atom (-O-), a sulfur atom (-S-), an imino (-NH-), a substituted imino (-NR-, wherein R is an aliphatic group, an aromatic group or a heterocyclic group) or a carbonyl (-CO-).

The aliphatic group may have a cyclic structure or a branched structure. The number of carbon atoms in the

aliphatic group is preferably from 1 to 20, more preferably from 1 to 15, and most preferably from 1 to 10. The aliphatic group is preferably a saturated aliphatic group rather than an unsaturated aliphatic group. The aliphatic group may have a substituent. Examples of the substituent include a halogen atom, a hydroxyl group, an aromatic group and a heterocyclic group.

The number of carbon atoms in the aromatic group is preferably from 6 to 20, more preferably from 6 to 15, and most preferably from 6 to 10. The aromatic group may have a substituent. Examples of the substituent include a halogen atom, a hydroxyl group, an aliphatic group, an aromatic group and a heterocyclic group.

The heterocyclic group preferably has a 5- or 6-membered ring as the heterocyclic ring. The heterocyclic ring may be condensed with another heterocyclic ring, an aliphatic ring or an aromatic ring. The heterocyclic group may have a substituent. Examples of the substituent include a halogen atom, a hydroxyl group, an oxo group (=O), a thioxo group (=S), an imino group (=NH), a substituted imino group (=N-R, wherein R is an aliphatic group, an aromatic group or a heterocyclic group), an aliphatic group, an aromatic group and a heterocyclic group.

L is preferably a divalent linking group containing a plurality of polyoxyalkylene structures. The polyoxyalkylene structure is preferably a polyoxyethylene structure. In other words, L preferably contains $-(OCH_2CH_2)_n-$(wherein n is an integer of 2 or more).

Z is a functional group which adsorbs to the hydrophilic support surface. The adsorptive functional group is as described above.

Y is a carbon atom or a nitrogen atom. When Y is a nitrogen atom and L is connected on Y to form a quaternary pyridinium group, the quaternary pyridinium group itself exhibits adsorptivity and therefore, Z is not essential.

Specific examples of representative monomers represented by formulae (VII) and (VIII) are set forth below.

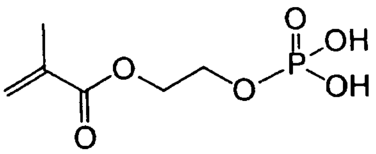

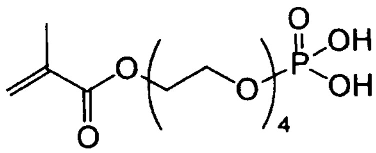

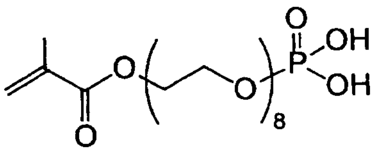

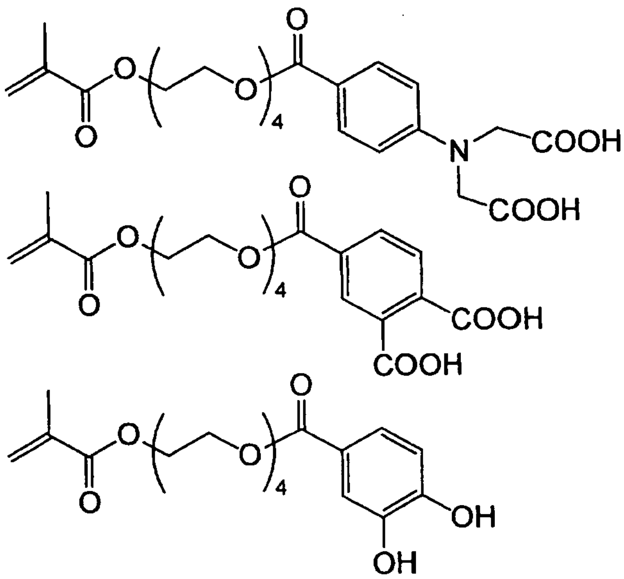

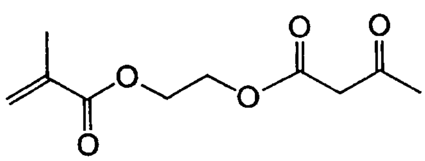

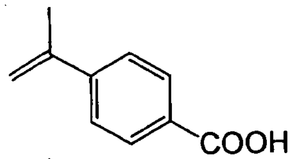

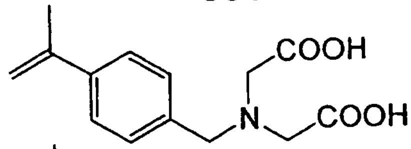

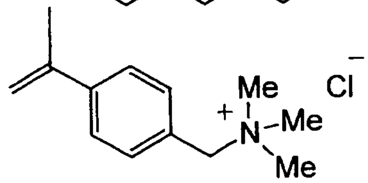

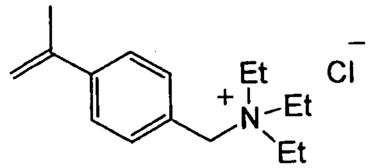

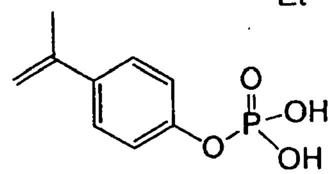

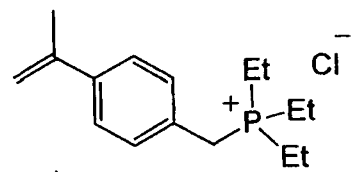

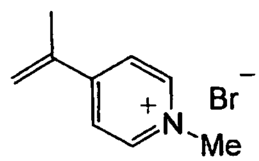

The polymer compound for use in the undercoat layer preferably further has a hydrophilic group. Suitable examples of the hydrophilic group include a hydroxy group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amide group, a carboxymethyl group, a sulfonic acid group and a phosphoric acid group.

In the present invention, in the case where a binder polymer having a cationic group in the side chain is used for the image recording layer, the hydrophilic group of the polymer compound for undercoating, that interacts with the binder polymer, is preferably an anionic group such as carboxyl group, carboxylate group, sulfonate group and phosphate group.

The polymer compound for undercoating used in the present invention preferably further has a crosslinking group. By virtue of the crosslinking group, adherence to the image part is enhanced. Crosslinking property may be imparted to the polymer compound for undercoating by introducing a crosslinking functional group such as ethylenically unsaturated bond into the side chain of the polymer, or by forming a salt structure with a compound containing an ethylenically unsaturated bond and a substituent having an opposite charge to the charge of the polar substituent on the polymer compound.

Examples of the monomer having an ethylenically unsaturated bond within the molecule include a monomer

which is an acrylic or methacrylic acid ester or amide and in which the ester or amide residue (R in -COOR or -CONHR) has an ethylenically unsaturated bond.

Examples of the residue (R above) having an ethylenically unsaturated bond include $-(CH_2)_nCR_1=CR_2R_3$, $-(CH_2O)_nCH_2CR_1=CR_2R_3$, $-(CH_2CH_2O)_nCH_2CR_1=CR_2R_3$, $-(CH_2)_nNH-CO-O-CH_2CR_1=CR_2R_3$, $-(CH_2)_n-O-CO-CR_1=CR_2R_3$ and $-(CH_2CH_2O)_2-X$ (wherein $R_1$ to $R_3$ each represents a hydrogen atom, a halogen atom or an alkyl, aryl, alkoxy or aryloxy group having a carbon number of 1 to 20, $R_1$ and $R_2$ or $R_3$ may combine together to form a ring, n represents an integer of 1 to 10, and X represents a dicyclopentadienyl residue).

Specific examples of the ester residue include $-CH_2CH=CH_2$, $-CH_2CH_2O-CH_2CH=CH_2$, $-CH_2C(CH_3)=CH_2$, $-CH_2CH=CH-C_6H_5$, $-CH_2CH_2OCOCH=CH-C_6H_5$, $-CH_2CH_2NHCOO-CH_2CH=CH_2$ and $CH_2CH_2O-X$ (wherein X represents a dicyclopentadienyl residue).

Specific examples of the amide residue include $-CH_2CH=CH_2$, $-CH_2CH_2O-Y$ (wherein Y represents a cyclohexene residue) and $-CH_2CH_2OCO-CH=CH_2$.

The content of the crosslinking group (content of radical-polymerizable unsaturated double bond determined by iodine titration) in the polymer compound for undercoating is preferably from 0.1 to 10.0 mmol, more preferably from 1.0 to 7.0 mmol, and most preferably from 2.0 to 5.5 mmol, per g of the polymer compound. Within this range, both good sensitivity and good staining resistance can be established, and good storage stability can be obtained.

The polymer compound for undercoat layer is preferably a polymer containing a monomer unit having an adsorptive group and a monomer unit having a hydrophilic group, more preferably a polymer containing a monomer unit having an adsorptive group, a monomer unit having a hydrophilic group, and a monomer unit having a crosslinking group.

Specific preferred examples of the polymer compound for undercoating are set forth below, but the present invention is not limited thereto.

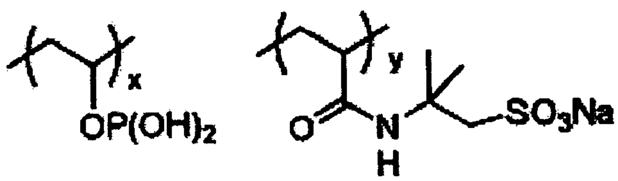

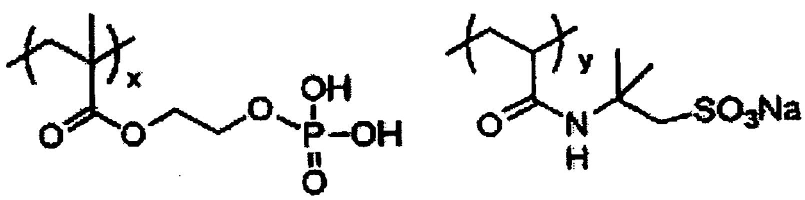

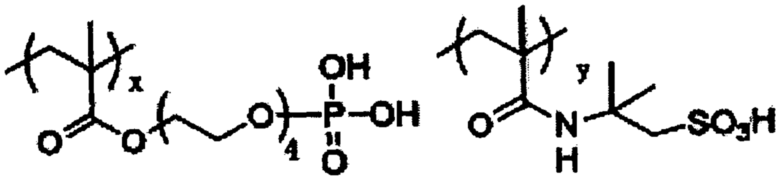

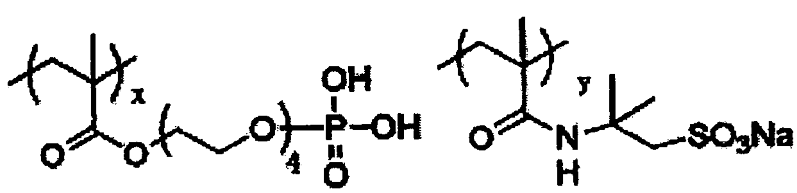

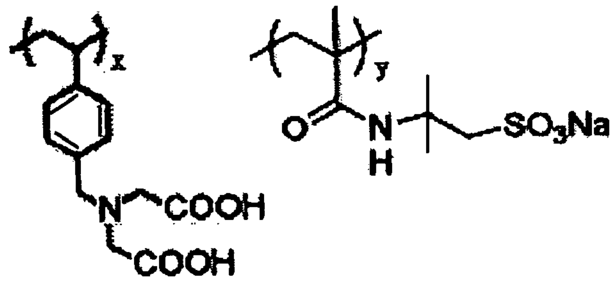

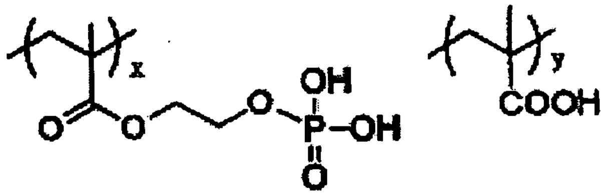

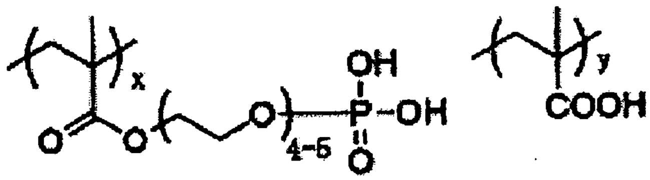

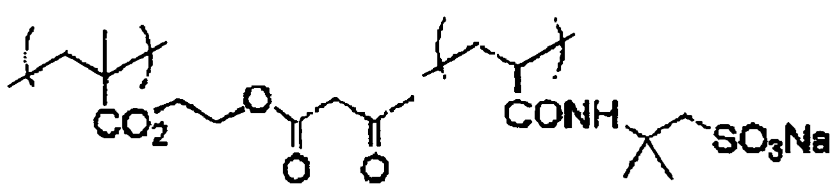

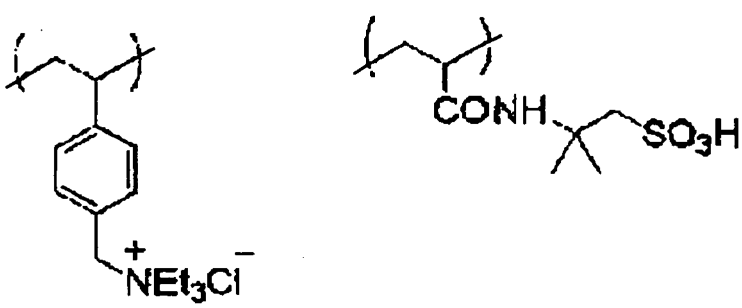

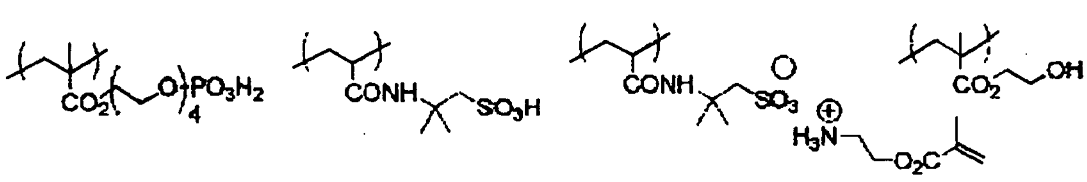

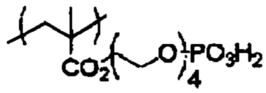 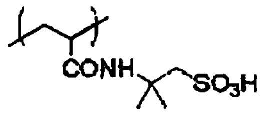 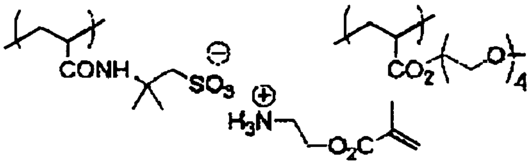

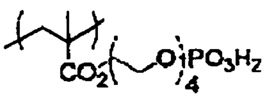 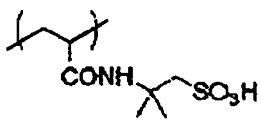 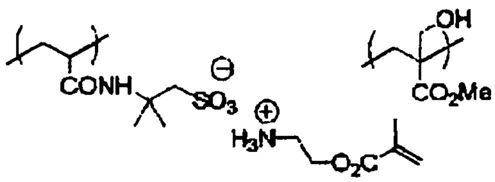

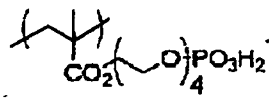 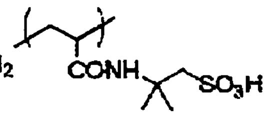 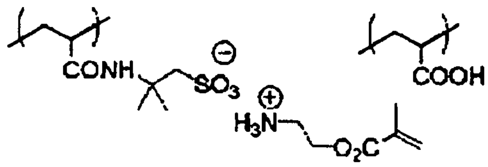

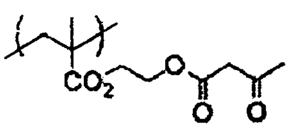 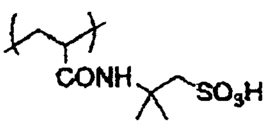 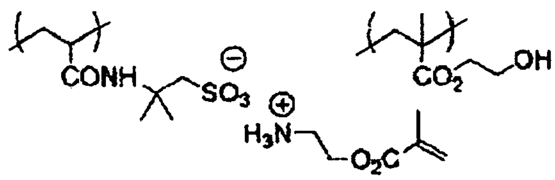

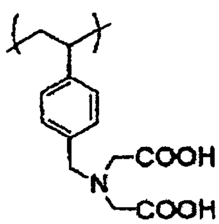 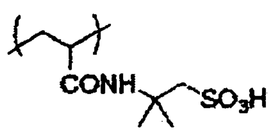 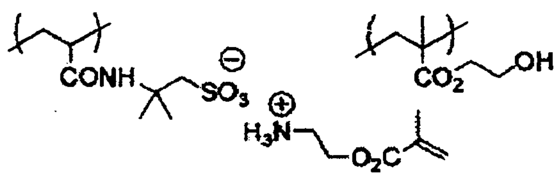

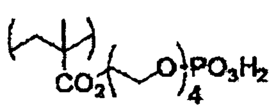 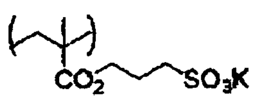 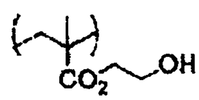

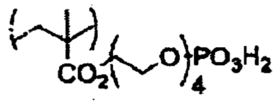 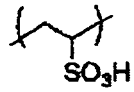 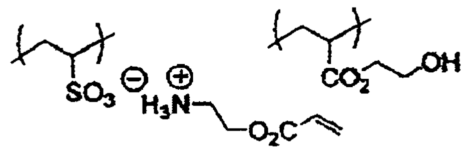

Furthermore, a copolymer having, for example, a repeating unit containing an ethylenically unsaturated bond described in JP-A-2005-125749 may also be preferably used.

The mass average molecular weight of the polymer compound for undercoating is preferably 5,000 or more, more preferably from 10,000 to 300,000, and the number average molecular weight is preferably 1,000 or more, more preferably from 2,000 to 250,000. The polydispersity (mass average molecular weight/number average molecular weight) is preferably from 1.1 to 10.

The polymer compound for undercoating may be any of a random polymer, a block polymer, a graft polymer and the like but is preferably a random polymer.

One of polymer compounds for undercoating may be used alone, or two or more kinds thereof may be mixed and used.

The coated amount (as solid content) of the undercoat layer is preferably from 0.1 to 100 $mg/m^2$, more preferably from 1 to 30 $mg/m^2$.

(Backcoat Layer)

After the support is subjected to a surface treatment or an undercoat layer is formed, a backcoat may be provided on the back surface of the support, if desired.

Suitable examples of the backcoat layer include a coat layer comprising an organic polymer compound described in JP-A-5-45885 and a coat layer comprising a metal oxide obtained by hydrolyzing and polycondensing an organic or inorganic metal compound described in JP-A-6-35174. Above all, use of an alkoxy compound of silicon, such as $Si(OCH_3)_4$, $Si(OC_2H_5)_4$, $Si(OC_3H_7)_4$ and $Si(OC_4H_9)_4$, is preferred because the raw material is inexpensive and easily available.

(Protective Layer)

In the lithographic printing plate precursor for use in the plate-making method of the present invention, a protective layer (oxygen-blocking layer) is preferably provided on the image forming layer so as to block the diffusion and intrusion of oxygen that inhibits the polymerization reaction during exposure. The protective layer for use in the invention preferably has an oxygen permeability A at 25°C under 1 atm of $1.0 \le A \le 20$ ($mL/m^2 \cdot day$). If the oxygen permeability A is extremely low and less than 1.0 ($mL/m^2 \cdot day$), this may cause a problem, for example, that an unnecessary polymerization reaction takes place during production or stock storage or that undesirable fog or thickening of image line occurs at the image exposure. On the contrary, if the oxygen permeability A is excessively high and exceeds 20 ($mL/m^2 \cdot day$), reduction in the sensitivity may be incurred. The oxygen permeability A is more preferably $1.5 \le A \le 12$ ($mL/m^2 \cdot day$), still more preferably $2.0 \le A \le 10.0$ ($mL/m^2 \cdot day$). In addition to the oxygen permeability, the characteristics required of the protective layer are to substantially not inhibit transmission of light used for exposure, exhibit excellent adherence to the image forming layer and be easily removable in the development step after exposure. Efforts regarding such a protective layer have been heretofore made and described in detail in U.S. Patent 3,458,311 and JP-B-55-49729.

As for the material of the protective layer, for example, a water-soluble polymer compound with relatively excellent crystallinity is preferably used. Specific examples thereof include a water-soluble polymer such as polyvinyl alcohol, vinyl alcohol/vinyl phthalate copolymer, vinyl acetate/vinyl alcohol/vinyl phthalate copolymer, vinyl acetate/crotonic acid copolymer, polyvinylpyrrolidone, acidic celluloses, gelatin, gum arabic, polyacrylic acid and polyacrylamide. These polymer compounds may be used individually or as a mixture. Out of these polymers, when polyvinyl alcohol is used as a main component, best results can be obtained in terms of fundamental characteristics such as oxygen-blocking property and removability by development.

The polyvinyl alcohol for use in the protective layer may be partially substituted by an ester, an ether or an acetal as long as it contains an unsubstituted vinyl alcohol unit for having required oxygen-blocking property and water solubility. Also, the polyvinyl alcohol may partially contain other copolymerization components. The polyvinyl alcohol specifically includes a polyvinyl alcohol having a hydrolysis degree of 71 to 100% and a number of polymerization repeating units of 300 to 2,400. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8, produced by Kuraray Co., Ltd. These polyvinyl alcohols may be used individually or as a mixture. In a preferred embodiment, the content of the polyvinyl alcohol in the protective layer is from 20 to 95 mass%, more preferably from 30 to 90 mass%.

A known modified polyvinyl alcohol may also be preferably used. Examples thereof include polyvinyl alcohols having various polymerization degrees and having various hydrophilic modified sites at random, such as anion-modified site modified with an anion (e.g., carboxyl, sulfo), cation-modified site modified with a cation (e.g., amino, ammonium), silanol-modified site and thiol-modified site; and polyvinyl alcohols having various polymerization degrees and having various modified sites at the polymer chain terminal, such as anion-modified site described above, cation modified site described above, silanol-modified site, thiol-modified site, alkoxy-modified site, sulfide-modified site, ester-modified site modified with an ester of vinyl alcohol and various organic acids, ester-modified site modified with an ester of the above-described anion-modified site and alcohols, and epoxy-modified site.

In view of oxygen-blocking property and removability by development, the component that is mixed and used with polyvinyl alcohol is preferably polyvinylpyrrolidone or a modified product thereof. The content thereof in the protective layer is from 3.5 to 80 mass%, preferably from 10 to 60 mass%, more preferably from 15 to 30 mass%.

The components (for example, selection of PVA and use of additives), coated amount and the like of the protective layer are selected by taking into account the prevention of fogging, adherence and scratch resistance in addition to the oxygen-blocking property and removability by development. In general, as the hydrolysis rate of PVA used is higher (namely, as the unsubstituted vinyl alcohol unit content in the protective layer is higher) or as the layer thickness is larger, the oxygen-blocking property becomes higher and this is preferred in view of sensitivity. The molecular weight of the polymer compound such as polyvinyl alcohol (PVA) is suitably from 2,000 to 10,000,000, preferably from 20,000 to 3,000,000.

As for other components of the protective layer, glycerin, dipropylene glycol or the like may be added in an amount corresponding to several mass% based on the polymer compound so as to impart flexibility. Also, an anionic surfactant such as sodium alkylsulfate and sodium alkylsulfonate; an amphoteric surfactant such as alkylaminocarboxylate and alkylaminodicarboxylate; or a nonionic surfactant such as polyoxyethylene alkylphenyl ether may be added in an amount of several mass% based on the polymer compound.

The adherence to the image part and scratch resistance are also very important in view of handling of the plate. More specifically, when a hydrophilic layer composed of a water-soluble polymer is stacked on the lipophilic image forming layer, film separation readily occurs due to insufficient adhesive force and in the separated portion, a defect such as curing failure ascribable to polymerization inhibition by oxygen may be caused. In order to solve this problem, various proposals have been made with an attempt to improve the adhesion between these two layers. For example, in U.S. Patent Application Nos. 292,501 and 44,563, it is indicated that sufficiently high adhesion can be obtained by mixing from 20 to 60 mass% of an acrylic emulsion, a water-insoluble vinylpyrrolidone-vinyl acetate copolymer or the like in a hydrophilic polymer mainly comprising polyvinyl alcohol and stacking the obtained solution on the image forming layer. To the protective layer in the present invention, these known techniques all can be applied. The coating method of such a protective layer is described in detail, for example, in U.S. Patent 3,458,311 and JP-B-55-49729.

Furthermore, for the purpose of enhancing the oxygen-blocking property or the surface protection of the image forming layer, it is also preferred to incorporate an inorganic layered compound into the protective layer of the lithographic printing plate precursor for use in the present invention.

Here, the inorganic layered compound is a particle having a thin tabular shape, and examples thereof include a mica family such as natural mica and synthetic mica, represented by the following formula:

$$A(B,C)_{2-5}D_4O_{10}(OH,F,O)_2,$$

[wherein A is any of K, Na and Ca, B and C each is any of Fe(II), Fe(III), Mn, Al, Mg and V, and D is Si or Al]; a talc represented by the formula: $3MgO \bullet 4SiO \bullet H_2O$; taeniolite; montmorillonite; saponite; hectorite; and zirconium phosphate.

Out of the mica family above, examples of the natural mica include muscovite, paragonite, phlogopite, biotite and lepidolite. Examples of the synthetic mica include a non-swelling mica such as fluorophlogopite $KMg_3(AlSi_3O_{10})F_2$ and potassium tetrasilicon mica $KMg_{2.5}(Si_4O_{10})F_2$; and a swelling mica such as Na tetrasilicic mica $NaMg_{2.5}(Si_4O_{10})F_2$, Na or Li taeniolite $(Na,Li)Mg_2Li(Si_4O_{10})F_2$, and montmorillonite-based Na or Li hectorite $(Na,Li)_{1/8}Mg_{2/5}Li_{1/8}(Si_4O_{10})F_2$. Synthetic smectite is also useful.

In the present invention, among these inorganic layered compounds, a fluorine-based swelling mica that is a synthetic inorganic layered compound is particularly useful. More specifically, the swelling clay minerals such as swelling synthetic mica, montmorillonite, saponite, hectorite and bentonite have a laminate structure comprising a unit crystal lattice layer having a thickness of approximately from 10 to 15 Å and are significantly larger in the extent of the intra-lattice metallic atom substitution than other clay minerals. As a result, the lattice layer causes lack of positive charge and in order to compensate for the lack, a cation such as $Na^+$, $Ca^{2+}$ and $Mg^{2+}$ is adsorbed between layers. The cation intervening between these layers is called an exchangeable cation and is exchanged with various cations. Particularly,

in the case where the cation between layers is $Li^+$ or $Na^+$, the bonding between layered crystalline lattices is weak due to small ionic radius, and great swelling with water occurs. When shearing is applied in this state, cleavage is readily brought about and a stable sol is formed in water. This tendency is strong in bentonite and swelling synthetic mica, and these compounds are useful in the present invention. In particular, swelling synthetic mica is preferred.

As for the shape of the inorganic layered compound for use in the present invention, the thickness is preferably smaller from the standpoint of controlling the diffusion, and the plane size is preferably larger as long as the flatness of coated surface or the transparency to actinic ray is not impaired. Accordingly, the aspect ratio is 20 or more, preferably 100 or more, more preferably 200 or more. The aspect ratio is a ratio of thickness to long diameter of a particle and can be measured, for example, from a projection drawing by a micrograph of particles. As the aspect ratio is larger, the effect obtained is greater.

The particle size of the inorganic layered compound for use in the present invention is, in terms of average long diameter, from 0.3 to 20 μm, preferably from 0.5 to 10 μm, more preferably from 1 to 5 μm. The average thickness of the particle is 0.1 μm or less, preferably 0.05 μm or less, more preferably 0.01 μm or less. For example, out of inorganic layered compounds, the swelling synthetic mica which is a representative compound has a size such that the thickness is from 1 to 50 nm and the plane size is approximately from 1 to 20 μm.

When such an inorganic layered compound particle having a large aspect ratio is incorporated into the protective layer, the coating strength is increased and the permeation of oxygen or water content can be effectively inhibited, so that the protective layer can be prevented from deterioration due to deformation or the like and even when stored for a long time under high-humidity condition, the lithographic printing plate precursor can be free of reduction in the image formability due to change of humidity and assured of excellent storage stability.

The content of the inorganic layered compound in the protective layer is preferably from 5/1 to 1/100 in terms of the mass ratio to the amount of binder used in the protective layer. Even when a plurality of kinds of inorganic layered compounds are used in combination, the total amount of these inorganic layered compounds is preferably in the above-described mass ratio range.

A general dispersion method for the inorganic layered compound used in the protective layer is described below. First, from 5 to 10 parts by mass of the swelling layered compound described above as a preferred inorganic layered compound is added to 100 parts by mass of water and after well wetting and swelling with water, dispersed by means of a dispersing machine. Examples of the dispersing machine used here include various mills of directly applying a mechanical force to effect dispersing, a high-speed stirring dispersing machine having a high shear force, and a dispersing machine giving a high-intensity ultrasonic energy. Specific examples thereof include a ball mill, a sand grinder mill, a viscomill, a colloid mill, a homogenizer, a dissolver, a Polytron, a homomixer, a homoblender, a KD mill, a jet agitator, a capillary emulsifier, a liquid siren, an electromagnetic strain ultrasonic generator, and an emulsifier having a Pohlman whistle. The dispersion containing from 5 to 10 mass% of the inorganic layered compound dispersed by the method above is highly viscous or gelled and exhibits extremely good storage stability. At the time of preparing the coating solution for protective layer by using this dispersion, the coating solution is preferably prepared by diluting the dispersion with water and after thoroughly stirring, blending it with a binder solution.

In this coating solution for protective layer, known additives such as surfactant for enhancing the coatability and water-soluble plasticizer for improving the physical properties of film can be added in addition to the inorganic layered compound. Examples of the water-soluble plasticizer include propionamide, cyclohexanediol, glycerin and sorbitol. A water-soluble (meth)acrylic polymer may also be added. Furthermore, in this coating solution, known additives for enhancing adherence to the image forming layer or aging stability of the coating solution may be added.

The thus-prepared coating solution for protective layer is coated on the image forming layer and then dried to form a protective layer. The coating solvent may be appropriately selected according to the binder but when a water-soluble polymer is used, distilled water or purified water is preferably used as the solvent. The coating method of the protective layer is not particularly limited, and known methods such as method described in U.S. Patent 3,458,311 and JP-B-55-49729 may be applied. Specific examples of the coating method for the protective layer include a blade coating method, an air knife coating method, a gravure coating method, a roll coating method, a spray coating method, a dip coating method and a bar coating method. Examples of the drying method include a method of blowing hot air on the coated surface, and a method of placing the support in a heated oven for a fixed time.

For producing a lithographic printing plate precursor used in the plate-making method of the present invention, the temperature on the support surface at the drying of the protective layer is preferably kept at a temperature not more than the thermal fusion bonding temperature of the thermal fusion bonding resin fine particle contained in the image forming layer, more preferably at a temperature 5°C lower than the thermal fusion bonding temperature. By keeping the drying temperature in this range, the thermal fusion bonding resin fine particle contained in the image forming layer can be caused to remain still in the fine particle form in the image forming layer.

The coated amount of the protective layer is preferably from 0.05 to 10 $g/m^2$ in terms of the coated amount after drying. In the case of containing an inorganic layered compound, the coated amount is more preferably from 0.1 to 0.5 $g/m^2$, and in the case of not containing an inorganic layered compound, the coated amount is more preferably

from 0.5 to 5 $g/m^2$.

(Plate-Making Method)

The plate-making method of a lithographic printing plate of the present invention uses a lithographic printing plate precursor prepared as above, wherein the lithographic printing plate precursor is imagewise exposed, developed to remove the non-image part and then heated at a temperature not lower than the thermal fusion bonding temperature of the thermal fusion bonding resin fine particle.

(Exposure)

The lithographic printing plate precursor is image-exposed through a transparent original having a line image, a halftone image or the like or image-exposed with laser light scanning or the like based on digital data. The wavelength of the exposure light source is preferably from 350 to 450 nm.

As for the available laser light source having a wavelength of 350 to 450 nm, the followings can be used.

A gas laser, specifically, Ar ion laser (364 nm, 351 nm, 10 mW to 1 W), Kr ion laser (356 nm, 351 nm, 10 mW to 1 W) or He-Cd laser (441 nm, 325 nm, 1 mW to 100 mW); a solid laser, specifically, a combination of Nd:YAG ($YVO_4$) with SHG crystalsxtwice (355 nm, 5 mW to 1 W), or a combination of Cr:LiSAF with SHG crystal (430 nm, 10 mW); a semiconductor laser system, specifically, a $KNbO_3$ ring resonator (430 nm, 30 mW), a combination of a waveguide-type wavelength conversion element with an AlGaAs or InGaAs semiconductor (380 nm to 450 nm, 5 mW to 100 mW), a combination of a waveguide-type wavelength conversion element with an AlGaInP or AlGaAs semiconductor (300 nm to 350 nm, 5 mW to 100 mW), or AlGaInN (350 nm to 450 nm, 5 mW to 30 mW); or a pulse laser, specifically, an $N_2$ laser (337 nm, pulse: 0.1 to 10 mJ) or XeF (351 nm, pulse 10 to 250 mJ), may be used. Among these light sources, an AlGaInN semiconductor laser (commercially available InGaN-based semiconductor laser: 400 to 410 nm, 5 to 30 mW) is preferred in view of the wavelength characteristics and cost.

As for the exposure apparatus of scanning exposure system for the lithographic printing plate precursor, the exposure mechanism includes an internal drum system, an external drum system and a flat bed system. As for the light source, out of the light sources described above, those capable of continuous oscillation may be preferably utilized. In practice, the following exposure apparatuses are preferred in view of relationship between the sensitivity of the lithographic printing plate precursor (hereinafter, sometimes referred to as a "photosensitive material") and the plate-making time:

a single beam to triple beam exposure apparatus of internal drum system, using one or more gas or solid laser light sources so as to provide a semiconductor laser having a total output of 20 mW or more,
a multi-beam (from 1 to 10 beams) exposure apparatus of flat bed system, using one or more semiconductor, gas or solid lasers so as to give a total output of 20 mW or more,
a multi-beam (from 1 to 9 beams) exposure apparatus of external drum system, using one or more semiconductor, gas or solid lasers so as to give a total output of 20 mW or more, and
a multi-beam (10 or more beams) exposure apparatus of external drum system, using one or more semiconductor or solid lasers so as to give a total output of 20 mW or more.

In such a laser direct drawing-type lithographic printing plate precursor, the following equation (eq. 1) is generally established among the sensitivity X ($J/cm^2$) of photosensitive material, the exposure area S ($cm^2$) of photosensitive material, the power q (W) of one laser light source, the number n of lasers and the total exposure time t (s):

$$X \cdot S = n \cdot q \cdot t \qquad \text{(eq. 1)}$$

i) In the Case of Internal Drum (Single Beam) System

The following equation (eq. 2) is generally established among the laser rotation number f (radian/s), the sub-scanning length Lx (cm) of photosensitive material, the resolution Z (dots/cm) and the total exposure time t (s):

$$f \cdot Z \cdot t = Lx \qquad \text{(eq. 2)}$$

ii) In the Case of External Drum (Multi-Beam) System

The following equation (eq. 3) is generally established among the drum rotation number F (radian/s), the sub-scanning length Lx (cm) of photosensitive material, the resolution Z (dots/cm), the total exposure time t (s) and the number (n) of beams:

$$F \bullet Z \bullet n \bullet t = Lx \qquad \text{(eq. 3)}$$

iii) In the Case of Flat Bed (Multi-Beam) System

The following equation (eq. 4) is generally established among the rotation number H (radian/s) of polygon mirror, the sub-scanning length Lx (cm) of photosensitive material, the resolution Z (dots/cm), the total exposure time t (s) and the number (n) of beams:

$$H \bullet Z \bullet n \bullet t = Lx \qquad \text{(eq. 4)}$$

When the resolution (2,560 dpi) required for a practical printing plate precursor, the plate size (A1/B1, sub-scanning length: 42 inch), the exposure condition of about 20 sheets/hour and the photosensitive characteristics (photosensitive wavelength, sensitivity: about 0.1 $mJ/cm^2$) of the lithographic printing plate precursor according to the present invention are substituted for the equations above, it can be understood that the lithographic printing plate precursor according to the present invention is preferably combined with a multi-beam exposure system using a laser having a total output of 20 mW or more. Furthermore, on taking account of operability, cost and the like, combination with a semiconductor laser multi-beam (10 or more beams) exposure apparatus of external drum system is most preferred.

Other examples of the exposure light source usable in the present invention include ultrahigh-pressure, high-pressure, medium-pressure and low-pressure mercury lamps, a chemical lamp, a carbon arc lamp, a xenon lamp, a metal halide lamp, various visible or ultraviolet laser lamps, a fluorescent lamp, a tungsten lamp and sunlight.

In the plate-making process of a lithographic printing plate precursor from a lithographic printing plate precursor according to the present invention, the entire plate surface may be heated, if desired, before or during exposure or between exposure and development. By this heating, the image-forming reaction in the photosensitive layer is accelerated, and advantageous effects such as improvement in the sensitivity and press life or stabilization of sensitivity can be obtained. Furthermore, for the purpose of enhancing the image strength and press life, it is also effective to perform entire post-heating or entire exposure of the image after development. Usually, the heating before development is preferably performed under mild conditions of a temperature of 150˚C or less. If the temperature is excessively high, there arises a problem such as fogging of even the non-image part. For the heating after development, very intense conditions are utilized, and the heating temperature is usually from 100 to 500˚C. If the temperature is low, a sufficient effect of strengthening the image may not be obtained, whereas if it is excessively high, a problem such as deterioration of the support or thermal decomposition of the image part may arise.

(Development)

The lithographic printing plate precursor for use in the present invention is image-exposed and then developed, whereby a lithographic printing plate is produced. The development processing includes (1) a method of developing the plate with an alkali developer (pH is higher than 10), (2) a method of developing the plate with a developer at a pH of 2 to 10, and (3) a method of developing the plate on a printing press while adding a fountain solution and/or an ink (on-press development). In the present invention, a method of developing the plate with a developer at a pH of 2 to 10 is employed. That is, after simultaneously removing the protective layer and the photosensitive layer in the non-image part with a developer at a pH of 2 to 10, the lithographic printing plate precursor of the present invention can be immediately set on a printing press and used for printing. In the normal development process of (1) using an alkali developer, the protective layer is removed in a pre-water washing step, alkali development is then performed, the alkali is removed in a post-water washing step, a gum treatment is performed in a gumming step, and the plate is dried in a drying step. In the present invention, the developer preferably contains a water-soluble polymer compound, and development and gumming are preferably performed at the same time. Accordingly, the post-water washing step is not particularly required, and it is preferred to perform development and gumming with one solution and then perform a drying step. Furthermore, the pre-water washing step is not particularly required, and removal of the protective layer is preferably performed at

the same time with development an gumming. Also, after the development and gumming, it is preferred to remove the excess developer by using a squeeze roller and then perform the drying. In the present invention, the development of the photosensitive lithographic printing plate precursor is performed in a usual manner at a temperature of 0 to 60˚C, preferably on the order of 15 to 40˚C, for example, by a method of dipping the exposed photosensitive lithographic printing plate precursor in a developer and rubbing the plate with a brush, or a method of spraying a developer and rubbing the plate with a brush.

The processing by such an automatic developing machine is advantageously liberated from the requirement for the measure against development scum originated in the protective layer/photosensitive layer, which is encountered in case of on-press development.

The developer used in the present invention is, for example, preferably water alone or an aqueous solution containing water as a main component (containing 60 mass% or more of water). In particular, an aqueous solution having the same composition as the conventionally known fountain solution, an aqueous solution containing a surfactant (e.g., anionic, nonionic, cationic, amphoteric), or an aqueous solution containing a water-soluble polymer compound is preferred, and an aqueous solution containing both a surfactant and a water-soluble polymer compound is more preferred. The pH of the developer is more preferably from 3 to 8, still more preferably from 4 to 7.

Examples of the anionic surfactant for use in the present invention include fatty acid salts, abietates, hydroxyalkanesulfonates, alkanesulfonates, dialkylsulfosuccinates, linear alkylbenzenesulfonates, branched alkylbenzenesulfonates, alkylnaphthalenesulfonates, alkylphenoxypolyoxyethylenepropylsulfonates, polyoxyethylenealkylsulfophenyl ether salts, an N-methyl-N-oleyltaurine sodium salts, monoamide disodium N-alkylsulfosuccinates, petroleum sulfonates, sulfated castor oil, sulfated beef tallow oil, sulfuric ester salts of fatty acid alkyl ester, alkylsulfuric ester salts, polyoxyethylene alkyl ether sulfuric ester salts, fatty acid monoglyceride sulfuric ester salts, polyoxyethylene alkylphenyl ether sulfuric ester salts, polyoxyethylene styrylphenyl ether sulfuric ester salts, alkylphosphoric ester salts, polyoxyethylene alkyl ether phosphoric ester salts, polyoxyethylene alkylphenyl ether phosphoric ester salts, partially saponified styrene-maleic anhydride copolymerization products, partially saponified olefin-maleic anhydride copolymerization products, and naphthalenesulfonate formalin condensates. Among these, dialkylsulfosuccinates, alkyl sulfate ester salts and alkylnaphthalenesulfonates are preferred.

The cationic surfactant for use in the present invention is not particularly limited and a conventionally known cationic surfactant can be used. Examples thereof include alkylamine salts, quaternary ammonium salts, polyoxyethylene alkylamine salts and polyethylene polyamine derivatives.

Examples of the nonionic surfactant for use in the present invention include a polyethylene glycol-type higher alcohol ethylene oxide adduct, an alkylphenol ethylene oxide adduct, a fatty acid ethylene oxide adduct, a polyhydric alcohol fatty acid ester ethylene oxide adduct, a higher alkylamine ethylene oxide adduct, a fatty acid amide ethylene oxide adduct, an ethylene oxide adduct of fat, a polypropylene glycol ethylene oxide adduct, a dimethylsiloxane-ethylene oxide block copolymer, a dimethylsiloxane-(propylene oxide-ethylene oxide) block copolymer, a fatty acid ester of polyhydric alcohol-type glycerol, a fatty acid ester of pentaerythritol, a fatty acid ester of sorbitol or sorbitan, a fatty acid ester of sucrose, an alkyl ether of polyhydric alcohol, and a fatty acid amide of alkanolamines.

In the present invention, an ethylene oxide adduct of sorbitol and/or sorbitan fatty acid ester, a polypropylene glycol ethylene oxide adduct, a dimethylsiloxane-ethylene oxide block copolymer, a dimethylsiloxane-(propylene oxide-ethylene oxide) block copolymer, and a fatty acid ester of polyhydric alcohol are preferred.

Also, in view of stable solubility in water or opacity, the nonionic surfactant for use in the developer of the present invention preferably has an HLB (hydrophilelipophile balance) value of 6 or more, more preferably 8 or more.

Furthermore, an oxyethylene adduct of acetylene glycol or acetylene alcohol, or a surfactant such as fluorine-containing or silicon-containing surfactant, may also be used.

Examples of the amphoteric surfactant for use in the present invention include a 2-alkylimidazoline derivative, an alkylaminoacetate, an alkyliminodiacetate, an alkylaminopropionate, an alkyliminodipropionate, an alkyldimethyl ammonioacetate, an alkylamidopropyldimethyl ammonioacetate, an alkylsulfobetaine, an alkyldiaminoethylglycine salt, and an alkylphosphobetaine. In the present invention, an alkylaminoacetate, an alkyliminodiacetate, an alkylaminopropionate, an alkyliminodipropionate, an alkyldimethyl ammonioacetate and an alkylamidopropyldimethyl ammonioacetate are preferred, and an alkyldimethyl ammonioacetate and an alkylamidopropyldimethyl ammonioacetate are more preferred.

The surfactant for use in the developer of the present invention is suitably a nonionic surfactant, an anionic surfactant or an amphoteric surfactant, more suitably a nonionic surfactant or an amphoteric surfactant.

One of a surfactant may be used alone, or two or more kinds of surfactants may be mixed and used. The content of the surfactant in the developer is preferably from 0.01 to 10 mass%, more preferably from 0.01 to 5 mass%.

Examples of the water-soluble polymer compound for use in the developer of the present invention include soybean polysaccharide, modified starch, gum arabic, dextrin, a cellulose derivative (e.g., carboxymethyl cellulose, carboxyethyl cellulose, methyl cellulose) and a modified product thereof, pullulan, polyvinyl alcohol and a derivative thereof, polyvinylpyrrolidone, polyacrylamide, an acrylamide copolymer, a vinyl methyl ether/maleic anhydride copolymer, a vinyl acetate/maleic anhydride copolymer, and a styrene/maleic anhydride copolymer.

As for the soybean polysaccharide, a known soybean polysaccharide can be used. For example, the soybean polysaccharide is commercially available under the trade name of Soyafive (produced by Fuji Oil Co., Ltd.), and various grade products may be used. Those having a viscosity of 10 to 100 mPa/sec in a 10 mass% aqueous solution can be preferably used. As for the modified starch, a known modified starch may also be used, and the modified starch can be produced, for example, by a method of decomposing starch such as corn, potato, tapioca, rice or wheat with an acid, an enzyme or the like in the range of the number of glucose residues per molecule being from 5 to 30, and further adding oxypropylene in an alkali.

Two or more kinds of water-soluble polymer compounds may be used in combination. The content of the water-soluble polymer compound in the developer is preferably from 0.1 to 20 mass%, more preferably from 0.5 to 10 mass%.

The developer for use in the present invention may contain an organic solvent. Examples of the organic solvent which can be contained include aliphatic hydrocarbons (e.g., hexane, heptane, "Isopar E, H and G" (produced by Esso Chemicals Ltd.), gasoline, kerosene), aromatic hydrocarbons (e.g., toluene, xylene), halogenated hydrocarbons (e.g., methylene dichloride, ethylene dichloride, trichlene, monochlorobenzene), and a polar solvent.

Examples of the polar solvent include alcohols (e.g., methanol, ethanol, propanol, isopropanol, benzyl alcohol, ethylene glycol monomethyl ether, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methylphenylcarbinol, n-amyl alcohol, methylamyl alcohol), ketones (e.g., acetone, methyl ethyl ketone, ethyl butyl ketone, methyl isobutyl ketone, cyclohexanone), esters (e.g., ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, butyl levulinate), and others (e.g., triethyl phosphate, tricresyl phosphate, N-phenylethanolamine, N-phenyldiethanolamine).

In the case where the organic solvent is insoluble in water, the organic solvent may be used after solubilizing it in water by using a surfactant or the like. In the case of containing an organic solvent in the developer, the concentration of the solvent is preferably less than 40 mass% in view of safety and inflammability.

In addition to those described above, the developer of the present invention may contain, for example, an antiseptic, a chelating compound, a defoaming agent, an organic acid, an inorganic acid and an inorganic salt.

Examples of the antiseptic which can be preferably used include phenol or a derivative thereof, formalin, an imidazole derivative, sodium dehydroacetate, a 4-isothiazolin-3-one derivative, benzisothiazolin-3-one, a benzotriazole derivative, an amidine-guanidine derivative, quaternary ammonium salts, derivatives of pyridine, quinoline and guanidine, diazine, a triazole derivative, oxazole, an oxazine derivative, nitrobromoalcohol-based 2-bromo-2-nitropropane-1,3-diol, 1-dibromo-1-nitro-2-ethanol and 1,1-dibromo-1-nitro-2-propanol.

Examples of the chelating compound include ethylenediaminetetraacetic acid and its potassium and sodium salts; diethylenetriaminepentaacetic acid and its potassium and sodium salts; triethylenetetraminehexaacetic acid and its potassium and sodium salts; hydroxyethylethylenediaminetriacetic acid and its potassium and sodium salts; nitrotriacetic acid and its sodium salt; 1-hydroxyethane-1,1-diphosphonic acid and its potassium and sodium salts; organic phosphonic acids such as aminotri(methylenephosphonic acid) and its potassium and sodium salts; and phosphonoalkane tricarboxylic acids. In place of the sodium and potassium salts of these chelating agents, organic amine salts are also effective.

As regards the defoaming agent, for example, a general self-emulsion-type or emulsion-type silicon-based compound, or a nonionic surfactant having an HLB of 5 or less may be used. A silicon defoaming agent is preferred. A silicon defoaming agent of any type such as emulsion dispersion type or solubilization type may be used.

Examples of the organic acid include citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid and an organic phosphonic acid. The organic acid may also be used in the form of an alkali metal salt or ammonium salt thereof.

Examples of the inorganic acid and inorganic salt include phosphoric acid, metaphosphoric acid, monoammonium phosphate, diammonium phosphate, monosodium phosphate, disodium phosphate, monopotassium phosphate, dipotassium phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium hydrogensulfate and nickel sulfate.

The developer above can be used as a developer and a development replenisher for an exposed lithographic printing plate precursor and is preferably applied to an automatic processor described later. In the case of performing the development by using an automatic processor, the developer becomes fatigued in accordance with the processing amount and therefore, the processing capacity can be recovered using a replenisher or a fresh developer. Such a replenishment system is preferably applied also to the plate-making method using a lithographic printing plate precursor of the present invention.

The development processing with the aqueous solution at a pH of 2 to 10 according to the present invention may be suitably performed by an automatic processor equipped with a developer supplying device and a rubbing member.

Examples of the automatic processor include an automatic processor where a rubbing treatment is performed while conveying the image-exposed lithographic printing plate precursor described in JP-A-2-220061 and JP-A-60-59351, and an automatic processor where a rubbing treatment of the image-exposed lithographic printing plate precursor set on a cylinder is performed while rotating the cylinder described in U.S. Patents 5,148,746 and 5,568,768 and British Patent 2,297,719. Above all, an automatic processor using a rotating brush roller as the rubbing member is preferred.

The rotating brush roller which can be preferably used in the present invention can be appropriately selected by taking into account, for example, scratch resistance of the image part and flexible strength of the support of the lithographic printing plate precursor. As for the rotating brush roller, a known rotating brush roller produced by implanting a brush material in a plastic or metal roller can be used. For example, a rotating brush roller described in JP-A-58-159533 and JP-A-3-100554, or a brush roller described in JP-UM-B-62-167253 (the term "JP-UM-B" as used herein means an "examined Japanese utility model publication"), in which a metal or plastic groove-type member having implanted therein a brush material in rows is gaplessly and radially wound around a plastic or metal roller acting as a core, can be used.

The usable brush material is a plastic fiber (for example, a polyester-based synthetic fiber such as polyethylene terephthalate or polybutylene terephthalate, a polyamide-based synthetic fiber such as nylon 6.6 or nylon 6.10, a polyacrylic synthetic fiber such as polyacrylonitrile or polyalkyl (meth)acrylate, or a polyolefin-based synthetic fiber such as polypropylene or polystyrene). For example, a brush material having a fiber bristle diameter of 20 to 400 $\mu$m and a bristle length of 5 to 30 mm can be suitably used. The outer diameter of the rotating brush roller is preferably from 30 to 200 mm, and the peripheral velocity at the tip of the brush rubbing the plate surface is preferably from 0.1 to 5 m/sec. A plurality (two or more) of rotating brush rollers are preferably used.

The rotational direction of the rotating brush roller for use in the present invention may be the same direction or the opposite direction with respect to the conveying direction of the lithographic printing plate precursor of the present invention, but in the case of using two or more rotating brush rollers as in the automatic processor illustrated in Fig. 2, it is preferred that at least one rotating brush roller rotates in the same direction and at least one rotating brush roller rotates in the opposite direction. By such arrangement, the image forming layer in the non-image part can be more unfailingly removed. Furthermore, a technique of rocking the rotating brush roller in the rotation axis direction of the brush roller is also effective.

The developer may be used at an arbitrary temperature but is preferably used at 10 to 50˚C.

In the production method of a lithographic printing plate of the present invention, post-drying is performed after the development, whereby a lithographic printing plate is obtained. Drying after development can be performed by a known method.

Incidentally, in the present invention, water washing and desensitization processing may be arbitrarily performed between the development and the drying step. In the desensitization processing, a known desensitizing solution may be used.

In the present invention, a lithographic printing plate is obtained by applying a development processing step after the exposure step, preferably after the heat-treating step. The plate setter used in the exposure step, the heat-treating means used in the heat treatment, and the developing apparatus used in the development processing step are preferably connected together to automatically perform the processing in a continuous manner. This is specifically a plate-making line where a plate setter and a developing apparatus are connected through conveying means such as conveyer. Also, heating means may be provided between the plate setter and the developing apparatus, or heating means may be integrated with the developing apparatus.

In the case where the lithographic printing plate precursor used is susceptible to ambient light in the working environment, the plate-making line is preferably shielded from light by a filter, a cover or the like.

(Post-Heating and/or Post-Exposure)

In the present invention, after the development step, the entire plate surface may be heated and/or exposed. By this treatment, the image is strengthened and higher press life can be obtained. In the case of heating the entire plate surface, the heating is performed using the above-described heating means at a temperature of 200 to 500˚C. If the temperature is low, a sufficient effect of strengthening the image may not be obtained, whereas if it is excessively high, a problem such as deterioration of the support or thermal decomposition of the image part may arise. In the case of exposing the entire plate surface, examples of the light source for the entire surface exposure include a carbon arc lamp, a mercury lamp, a gallium lamp, a metal halide lamp, a xenon lamp, a tungsten lamp and various lasers. In order to obtain a sufficiently high press life, the entire surface exposure amount is preferably at least 10 mJ/$cm^2$ or more, more preferably 100 mJ/$cm^2$ or more. These heating and exposure may be performed individually or may be performed at the same time or continuously in sequence.

EXAMPLES

The present invention is described in greater detail below by referring to the Examples, but the present invention should not be construed as being limited thereto.

<Production of Lithographic Printing Plate Precursor (1)>

(Production of Aluminum Support 1)

A 0.24 mm-thick aluminum plate (material 1050, temper H16) was degreased by dipping the plate in an aqueous 5% sodium hydroxide solution kept at 65˚C for one minute and then washed with water. This degreased aluminum plate was neutralized by dipping it in an aqueous 10% hydrochloric acid solution kept at 25˚C for 1 minute and then washed with water. This aluminum plate was then subjected to an electrolytic surface-roughening treatment for 60 seconds in an aqueous 0.3 mass% hydrochloric acid solution under the conditions of 25˚C and a current density of 100 A/dm$^2$ by passing an alternating current and further to a desmutting treatment for 10 seconds in an aqueous 5% sodium hydroxide solution kept at 60˚C. The surface-roughened aluminum plate after the desmutting treatment was then subjected to an anodization treatment for 1 minute in an aqueous 15% sulfuric acid solution at 25˚C under the conditions of a current density of 10 A/dm$^2$ and a voltage of 15 V. Thereafter the following coating solution for undercoat layer was coated to produce a support.

(Formation of Underlying Layer)

On the surface of the aluminum support obtained above, a coating solution for undercoat layer having the following composition was coated to give a dry coated amount of 10 mg/m$^2$ and dried at 100˚C for 1 minute to form an underlying layer.

<Coating Solution for Undercoat Layer>

| | |
|---|---|
| Polyvinylphosphonic acid | 1 g |
| Methanol | 600 g |
| Distilled water | 400 g |

(Formation of Image Forming Layer)

On the aluminum support after providing an underlying layer as above, Coating Solution 1 for Image Forming Layer having the following composition was coated to give a dry coated amount of 1.3 g/m$^2$ and dried at 75˚C for 1 minute to form an image forming layer.

<Coating Solution 1 for Image Forming Layer>

| | |
|---|---|
| Radical polymerizable compound: isocyanuric acid EO-modified triacrylate (Aronics M-315, produced by Toa Gosei Co., Ltd.) | 0.40 g |
| Radical polymerizable compound: ethoxylated trimethylolpropane triacrylate (SR9035, produced by Nippon Kayaku Co., Ltd., EO addition molar number: 15) | 0.13 g |
| Binder Polymer (1) shown below | 0.54 g |
| Radical Polymerization Initiator (1) shown below | 0.18 g |
| Acid Generator (1) shown below | 0.14 g |
| Sensitizing Dye (1) shown below | 0.06 g |
| Chain Transfer Agent (1) shown below | 0.07 g |
| Acid Crosslinking Agent (1) shown below | 0.40 g |
| Methylene Blue | 0.02 g |
| Thermal polymerization inhibitor: N-nitrosophenylhydroxylamine aluminum salt | 0.01 g |

(continued)

| | |
|---|---|
| 1-Methoxy-2-propanol | 2.5 g |
| Acetone | 7.0 g |
| Distilled water | 10.0 g |

Binder Polymer (1):

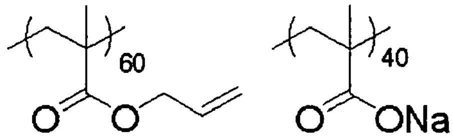

[Mass average molecular weight: 100,000]

Sensitizing Dye (1):

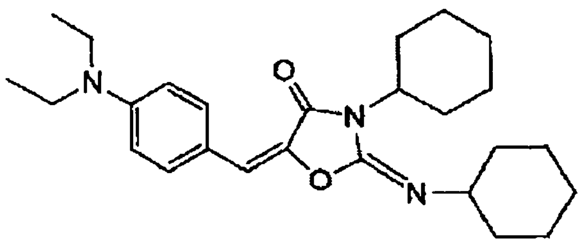

Polymerization Initiator (1):

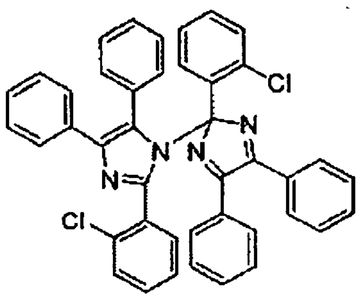

Chain Transfer Agent (1):

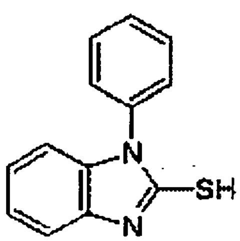

Acid Generator (1):

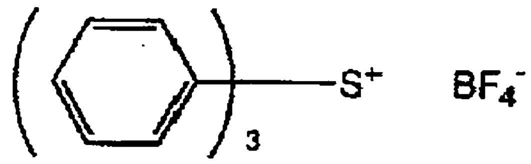

Acid Crosslinking Agent (1):

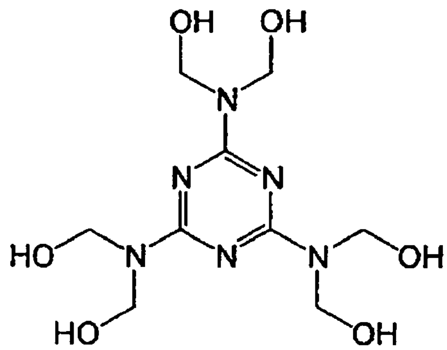

(Formation of Protective Layer)

On the image forming layer formed above, Coating Solution (1) for Protective Layer having the following composition was coated to give a dry coated mass of 0.3 g/m$^2$ and dried at 75°C for 1 minute to provide a protective layer.

<Coating Solution (1) for Protective Layer>

| | |
|---|---|
| Mica Liquid Dispersion (1) shown below | 13.00 g |
| Polyvinyl alcohol (PVA-105 (produced by Kuraray Co., Ltd.), saponification degree: 98 mol%, polymerization degree: 500) | 1.30 g |
| Sodium 2-ethylhexylsulfosuccinate | 0.20 g |
| Poly(vinylpyrrolidone/vinyl acetate (1/1)), molecular weight: 70,000 | 0.05 g |
| Surfactant (EMALEX 710, produced by Nihon Emulsion Co., Ltd.) | 0.05 g |
| Water | 133.00 g |

(Preparation of Mica Liquid Dispersion (1))

In 368 g of water, 32 g of synthetic mica ("SOMASIF ME-100", produced by CO-OP Chemical Co., Ltd., aspect ratio: 1,000 or more) was added and dispersed using a homogenizer until the average particle diameter (as determined by the laser scattering method) became 0.5 μm to obtain Mica Liquid Dispersion (1).

[Example 1]

(1) Exposure, Development and Printing

Lithographic Printing Plate Precursor (1) was image-exposed using a violet semiconductor laser plate setter, Vx9600 (having mounted thereon an InGaN-based semiconductor laser with light emission of 405 nm±10 nm/output of 30 mW)) manufactured by FUJIFILM Electronic Imaging Ltd. The image was drawn as a 50% flat tint image with a plate surface exposure amount of 0.05 mJ/cm$^2$ at a resolution of 2,438 dpi by using FM Screen (TAFFETA 20) manufactured by Fujifilm Corp.

Subsequently, in the pre-heating part of the automatic development processor shown in Fig. 1, the entire surface of the lithographic printing plate precursor was heated at a temperature shown in Table 1. Incidentally, the time taken for the plate to pass through the pre-heating part was 1 minute. Thereafter, development processing was performed in the same manner as above and further, drying treatment was performed at 100˚C to produce a lithographic printing plate.
After the pre-heating step, Developer (1) having the following composition was charged into the developing bath of the automatic development processor having a structure shown in Fig. 1 and then development processing was performed. The pH of the developer was 8.
After the development, without using water washing and finishing baths, drying was directly performed at 100˚C to obtain Lithographic Printing Plate (1).

Developer (1):

| | |
|---|---|
| Water | 100.00 g |
| Benzyl alcohol | 1.00 g |
| Polyoxyethylene naphthyl ether (average number n of oxyethylenes = 13) | 1.00 g |
| Sodium salt of dioctylsulfosuccinic acid ester | 0.50 g |
| Gum arabic (Mw: 250,000) | 1.00 g |
| Ethylene glycol | 0.50 g |
| Monoammonium phosphate | 0.05 g |
| Citric acid | 0.05 g |
| Ethylenediaminetetraacetate tetrasodium salt | 0.05 g |

[Comparative Example 1]

Comparative Lithographic Printing Plate Precursor (1) and Comparative Lithographic Printing Plate (1) of Comparative Example 1 were obtained in the same manner as in Example 1 except that in Example 1, an acid generator and an acid crosslinking agent were not contained in Coating Solution 1 for Image Forming Layer.

(2) Evaluation

The lithographic printing plate obtained by developing the lithographic printing plate precursor produced above was loaded on a printing press, SOR-M, manufactured by Heidelberg, and printing was performed at a printing speed of 6,000 sheets/hour by using a fountain solution (EU-3 (etching solution produced by Fujifilm Corp.)/water/isopropyl alcohol = 1/89/10 (by volume)) and a black ink, TRANS-G(N) (produced by Dai-Nippon Ink Chemical Co., Ltd.). The developability, sensitivity, press life and staining resistance were evaluated according to the following evaluation methods. The result are shown in Table 1.

<Sensitivity>

Imagewise exposure was performed by varying the energy density and after printing 100 sheets as above and confirming that a printed matter free from ink staining in the non-image part was obtained, 500 sheets were subsequently printed. With respect to these 600 printed matters in total, the exposure amount ($mJ/cm^2$) at which the ink density of the image part was free of unevenness was evaluated as the sensitivity.

<Developability>

The lithographic printing plate precursor was exposed and developed in the same manner as above, and the non-image part of the obtained lithographic printing plate was confirmed with an eye. The presence or absence of the remaining of photosensitive layer was evaluated according to the following criteria.

A: No residual film.
B: Slight residual film.
C: Residual film was observed.

<Conveying Speed>

Using the above-described automatic development processor, the conveying speed of the lithographic printing plate precursor was varied and the maximum conveying speed (cm/min) at which the non-image part could be completely removed was determined. A higher conveying speed indicates higher developability.

<Press Life, Staining Resistance>

When printing was performed in the same manner as above, the image part was gradually abraded with an increase in the number of sheets printed and decreased in the ink receptivity and in turn, the ink density on the printed sheet was lowered. The press life was evaluated by the number of sheets printed until the ink density (reflection density) was decreased by 0.1 than that at the initiation of printing. At this time, the presence or absence of staining of the non-image part was also evaluated with an eye.

A: Staining was not observed at all.
B: Staining was scarcely observed.
C: Staining was slightly observed
D: Staining was clearly observed.

[Table 1]

| | Lithographic Printing Plate Precursor | Developability | Conveying Speed cm/min | Sensitivity mJ/cm$^2$ | Press Life | Staining Resistance | Remarks |
|---|---|---|---|---|---|---|---|
| Example 1 | (1) | A | 120 | 0.14 | 42000 | B | |
| Comparative Example 1 | (1) of Comparative Example | A | 120 | 0.15 | 30000 | B | control |

As apparent from Table 1, according to the present invention, the printing plate precursor exhibits good developability, good staining resistance and excellent sensitivity and can provide a lithographic printing plate with excellent press life.

<Production of Lithographic Printing Plate Precursors (2) to (5)>

Lithographic Printing Plate Precursors (2) to (5) were produced in the same manner as Lithographic Printing Plate Precursor (1) except that Binder Polymer (1) in Coating Solution 1 for Image Forming Layer was changed to the following Binder Polymers (2) to (5).

Binder Polymer (2):

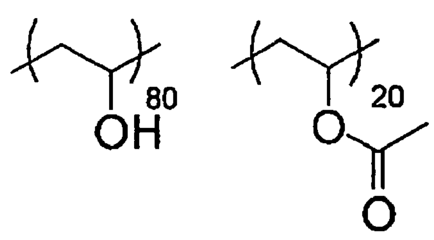

[Mass average molecular weight: 100,000]

Binder Polymer (3):

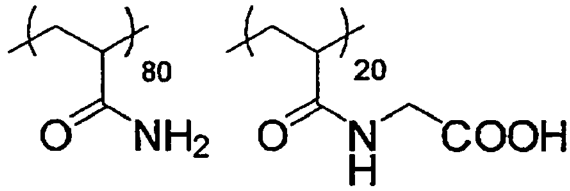

[Mass average molecular weight: 80,000]

Binder Polymer (4):

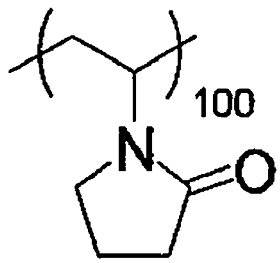

[Mass average molecular weight: 150,000]

Binder Polymer (5):

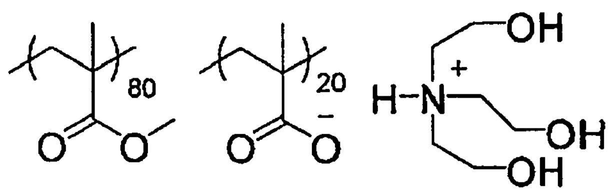

[Mass average molecular weight: 50,000]

<Production of Comparative Lithographic Printing Plate Precursors (2) to (5)>

Comparative Lithographic Printing Plate Precursors (2) to (5) were produced in the same manner as Comparative Lithographic Printing Plate Precursor (1) except that Binder Polymer (1) in Coating Solution 1 for Image Forming Layer was changed to Binder Polymers (2) to (5).

[Examples 2 to 5 and Comparative Examples 2 to 5]

The thus-obtained Lithographic Printing Plate Precursors (2) to (5) and Comparative Lithographic Printing Plate Precursors (2) to (5) were evaluated in the same manner as in Example 1. The results are shown in Table 2.

[Table 2]

| | Lithographic Printing Plate Precursor | Developability | Conveying Speed cm/min | Sensitivity mJ/cm$^2$ | Press Life | Staining Resistance | Remarks |
|---|---|---|---|---|---|---|---|
| Example 2 | (2) | A | 120 | 0.14 | 38000 | A | |
| Comparative Example 2 | (2) of Comparative Example | A | 120 | 0.15 | 30000 | A | control |
| Example 3 | (3) | A | 120 | 0.14 | 35000 | A | |
| Comparative Example 3 | (3) of Comparative Example | A | 120 | 0.15 | 30000 | A | control |
| Example 4 | (4) | A | 120 | 0.14 | 40000 | A | |
| Comparative Example 4 | (4) of Comparative Example | A | 120 | 0.15 | 30000 | A | control |
| Example 5 | (5) | A | 120 | 0.14 | 40000 | A | |
| Comparative Example 5 | (5) of Comparative Example | A | 120 | 0.15 | 30000 | A | control |

As apparent from Table 2, when the plate-making method of a lithographic printing plate of the present invention is used, the same results can be obtained by using any hydrophilic binder.

<Production of Lithographic Printing Plate Precursors (6) to (8)>

Lithographic Printing Plate Precursors (6) to (8) were produced in the same manner as Lithographic Printing Plate Precursor (1) except that Binder Polymer (1) in Coating Solution 1 for Image Forming Layer was changed to the following Binder Polymers (6) to (8).

Binder Polymer (6):

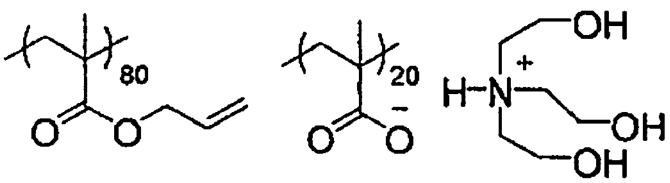

[Mass average molecular weight: 50,000]

Binder Polymer (7):

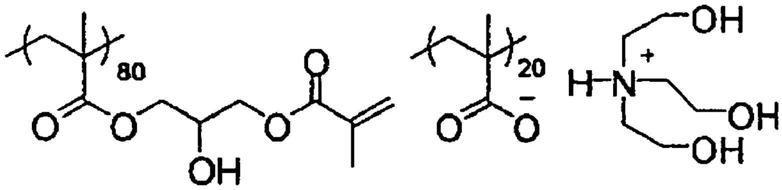

[Mass average molecular weight: 50,000]

Binder Polymer (8):

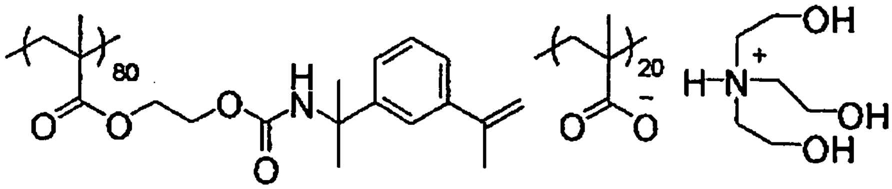

[Mass average molecular weight: 50,000]

<Production of Comparative Lithographic Printing Plate Precursors (6) to (8)>

Comparative Lithographic Printing Plate Precursors (6) to (8) were produced in the same manner as Comparative Lithographic Printing Plate Precursor (1) except that Binder Polymer (1) in Coating Solution 1 for Image Forming Layer was changed to Binder Polymers (6) to (8).

[Examples 6 to 8 and Comparative Examples 6 to 8]

The thus-obtained Lithographic Printing Plate Precursors (6) to (8) and Comparative Lithographic Printing Plate Precursors (6) to (8) were evaluated in the same manner as in Example 1. Incidentally, Comparative Lithographic Printing Plate Precursors (6) to (8) were used as the control photosensitive material of evaluation. The results are shown in Table 3.

[Table 3]

| | Lithographic Printing Plate Precursor | Developability | Conveying Speed cm/min | Sensitivity | Press Life | Staining Resistance | Remarks |
|---|---|---|---|---|---|---|---|
| Example 6 | (6) | A | 120 | 0.14 | 43000 | B | |
| Comparative Example 6 | (6) of Comparative Example | A | 120 | 0.15 | 30000 | B | control |
| Example 7 | (7) | A | 120 | 0.14 | 45000 | B | |
| Comparative Example 7 | (7) of Comparative Example | A | 120 | 0.15 | 30000 | B | control |
| Example 8 | (8) | A | 120 | 0.14 | 44000 | B | |

(continued)

| | Lithographic Printing Plate Precursor | Developability | Conveying Speed cm/min | Sensitivity | Press Life | Staining Resistance | Remarks |
|---|---|---|---|---|---|---|---|
| Comparative Example 8 | (8) of Comparative Example | A | 120 | 0.15 | 30000 | B | control |

As apparent from Table 3, when the plate-making method of a lithographic printing plate of the present invention is applied to a lithographic printing plate precursor using a hydrophilic binder having a polymerizable group, a remarkable effect can be obtained.

<Production of Lithographic Printing Plate Precursors (9) to (11)>

Lithographic Printing Plate Precursors (9) to (11) were produced in the same manner as Lithographic Printing Plate Precursor (1) except that the acid crosslinking agent in Coating Solution 1 for Image Forming Layer was changed to the following Compounds (2) to (4).

Acid Crosslinking Agent (2):

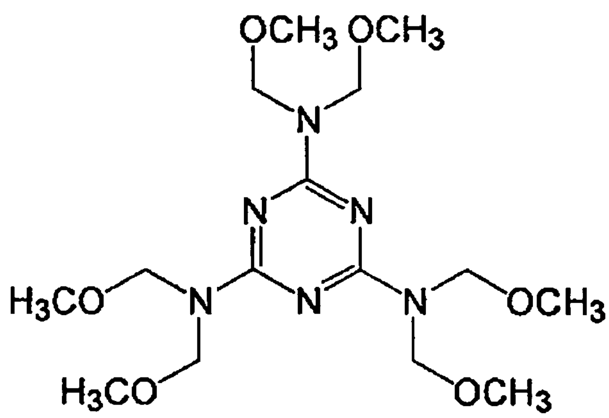

Acid Crosslinking Agent (3):

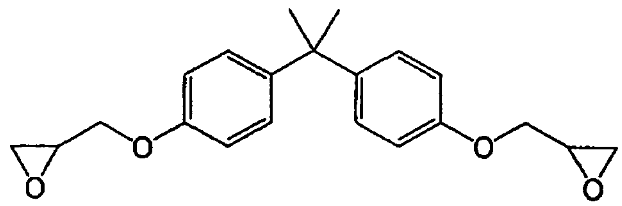

Acid Crosslinking Agent (4):

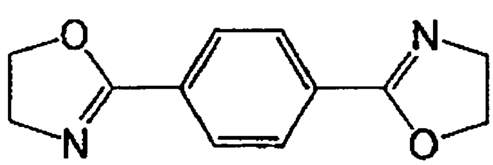

[Examples 9 to 11]

The thus-obtained Lithographic Printing Plate Precursors (9) to (11) were evaluated in the same manner as in Example 1. Incidentally, Comparative Lithographic Printing Plate Precursor (1) was used as the control photosensitive material of evaluation. The results are shown in Table 4.

[Table 4]

| | Lithographic Printing Plate Precursor | Developability | Conveying Speed cm/min | Sensitivity | Press Life | Staining Resistance | Remarks |
|---|---|---|---|---|---|---|---|
| Example 9 | (9) | A | 120 | 0.14 | 43000 | B | |
| Example 10 | (10) | A | 120 | 0.14 | 41000 | B | |
| Example 11 | (11) | A | 120 | 0.14 | 41000 | B | |
| Comparative Example 1 | (1) of Comparative Example | A | 120 | 0.15 | 30000 | B | control |

As apparent from Table 4, a remarkable effect can be obtained by the plate-making method of a lithographic printing plate of the present invention.

## Claims

1. A plate-making method of a lithographic printing plate, comprising:

   subjecting a lithographic printing plate precursor comprising, in the following order: a support; an image forming layer; and a protective layer, to image exposure with a laser; and
   simultaneously removing the protective layer and unexposed area of the image forming layer by an automatic processor in the presence of a developer having pH of from 2 to 10,

   wherein the image forming layer comprises a binder polymer, a polymerizable compound, a polymerization initiator, an acid crosslinking agent and an acid generator.

2. The plate-making method of a lithographic printing plate as claimed in claim 1, wherein the binder polymer has a hydrophilic group.

3. The plate-making method of a lithographic printing plate as claimed in claim 2, wherein the hydrophilic group is at least one member selected from a primary amino group, a secondary amino group, a tertiary amino group, a salt obtained by neutralizing an amino group with an acid, a quaternary ammonium group, an amide group, a hydroxy group, and a salt obtained by neutralizing a carboxylic acid with an ammonium group.

4. The plate-making method of a lithographic printing plate as claimed in any one of claims 1 to 3, wherein the acid crosslinking agent is a nitrogen-containing crosslinking agent.

5. The plate-making method of a lithographic printing plate as claimed in any one of claims 1 to 4, wherein the acid generator is an onium salt.

6. The plate-making method of a lithographic printing plate as claimed in any one of claims 1 to 5, wherein the image forming layer further comprises a sensitizing dye.

7. The plate-making method of a lithographic printing plate as claimed in any one of claims 1 to 6, wherein the lithographic printing plate precursor after image exposure with a laser is heat-treated and subjected to removal of the unexposed area of the image forming layer in the presence of a developer having pH of from 2 to 10.

8. The plate-making method of a lithographic printing plate as claimed in any one of claims 1 to 6, wherein the lithographic

printing plate precursor after image exposure with a laser is subjected to removal of the unexposed area of the image forming layer in the presence of a developer having pH of from 2 to 10 and then heat-treated.

FIG. 1

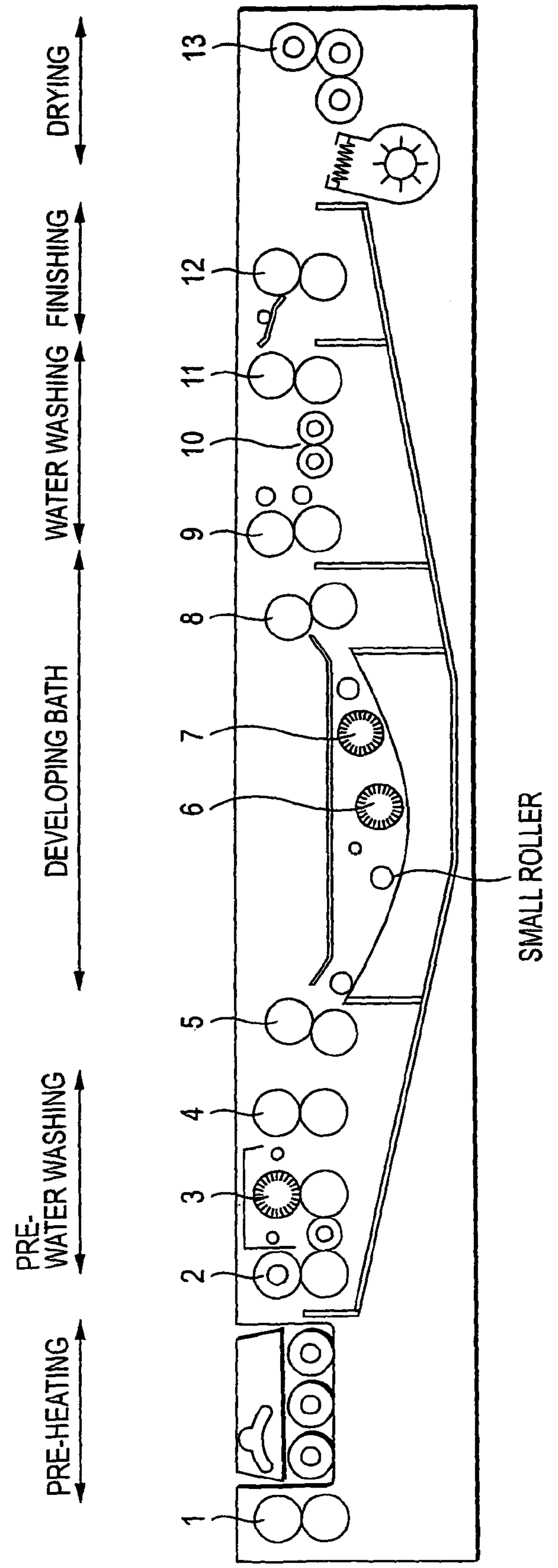
PRE-HEATING
PRE-
WATER WASHING
DEVELOPING BATH
WATER WASHING
FINISHING
DRYING
1
2
3
4
5
6
7
8
9
10
11
12
13
SMALL ROLLER

Europäisches Patentamt
European Patent Office
Office européen des brevets

# EUROPEAN SEARCH REPORT

Application Number
EP 09 00 4495

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 1 630 603 A (KONICA MINOLTA MED & GRAPHIC [JP]) 1 March 2006 (2006-03-01)<br>* paragraphs [0001], [0004], [0126], [0127], [0105] - [0111]; claim 7 *<br>* paragraphs [0137], [0138], [0141], [0143], [0145], [0149] - [0151]; example 2; table 2 *<br>* paragraphs [0054], [0056] *<br>* paragraphs [0071] - [0094], [0149] *<br>* paragraphs [0128], [0143] *<br>----- | 1-8 | INV.<br>G03F7/029<br>G03F7/038<br>G03F7/11<br>G03F7/30<br>G03F7/38<br>G03F7/40<br>B41C1/10<br><br>ADD.<br>G03F7/32 |
| Y | JP 2007 328107 A (FUJIFILM CORP) 20 December 2007 (2007-12-20)<br>* paragraphs [0003], [0004]; claim 1 *<br>* paragraphs [0198], [0199], [0262] *<br>* paragraphs [0164] - [0168], [0253] *<br>* paragraphs [0070], [0083] *<br>* paragraphs [0089] - [0099]; compounds S-17 *<br>* paragraphs [0015] - [0051], [0249], [0223] *<br>----- | 1-8 | TECHNICAL FIELDS SEARCHED (IPC) |
| Y | US 2005/037286 A1 (HIRABAYASHI KAZUHIKO [JP] ET AL) 17 February 2005 (2005-02-17)<br>* the whole document *<br>* paragraph [0182] *<br>----- | 1-8 | G03F<br>B41C |
| A | EP 1 452 916 A (KONICA MINOLTA HOLDINGS INC [JP]) 1 September 2004 (2004-09-01)<br>* the whole document *<br>----- | 1-8 | |
| A | EP 0 938 026 A (DSM NV [NL]; JSR CORP [JP]; JAPAN FINE COATINGS CO LTD [JP] DSM IP ASS) 25 August 1999 (1999-08-25)<br>* the whole document *<br>----- | 1,5,7,8 | |

The present search report has been drawn up for all claims

1

| Place of search | Date of completion of the search | Examiner |
|---|---|---|
| Munich | 7 July 2009 | Beckert, Audrey |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 09 00 4495

This annex lists the patent family members relating to the patent documents cited in the above-mentioned European search report.
The members are as contained in the European Patent Office EDP file on
The European Patent Office is in no way liable for these particulars which are merely given for the purpose of information.

07-07-2009

| Patent document cited in search report | Publication date | Patent family member(s) | Publication date |
|---|---|---|---|
| EP 1630603 A | 01-03-2006 | JP 4161858 B2 | 08-10-2008 |
| | | JP 2005018012 A | 20-01-2005 |
| | | WO 2004109402 A1 | 16-12-2004 |
| | | US 2007020555 A1 | 25-01-2007 |
| JP 2007328107 A | 20-12-2007 | NONE | |
| US 2005037286 A1 | 17-02-2005 | JP 4161850 B2 | 08-10-2008 |
| | | JP 2004361911 A | 24-12-2004 |
| EP 1452916 A | 01-09-2004 | US 2004157154 A1 | 12-08-2004 |
| EP 0938026 A | 25-08-1999 | US 6287745 B1 | 11-09-2001 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 4708925 A
- JP 8276558 A
- US 2850445 A
- JP 4420189 B
- JP 2938397 B
- JP 2000211262 A
- JP 2001277740 A
- JP 2002029162 A
- JP 2002046361 A
- JP 2002137562 A
- JP 2002326470 A
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B
- JP 46043946 B
- JP 1040337 B
- JP 1040336 B
- JP 2025493 A
- JP 61022048 A
- JP 4537377 B
- JP 4486516 B
- JP 2001343742 A
- JP 2002148790 A
- JP 2007171406 A
- JP 2007206216 A
- JP 2007206217 A
- JP 2007225701 A
- JP 2007225702 A
- JP 2007316582 A
- JP 2007328243 A
- JP 7020629 A
- JP 7271029 A
- JP 11119421 A
- JP 10016423 A
- JP 9197671 A
- JP 2007058170 A
- JP 2001133969 A
- JP 2002278057 A
- JP 2001277742 A
- US 2800457 A
- US 2800458 A
- US 3287154 A
- JP 3819574 B
- JP 42446 B
- US 3418250 A
- US 3660304 A
- US 3796669 A
- US 3914511 A
- US 4001140 A
- US 4087376 A
- US 4089802 A
- US 4025445 A
- JP 369163 B
- JP 51009079 A
- GB 930422 A
- US 3111407 A
- GB 952807 A
- GB 967074 A
- JP 2002287334 A
- JP 54063902 A
- JP 2001253181 A
- JP 2001322365 A
- US 2714066 A
- US 3181461 A
- US 3280734 A
- US 3902734 A
- JP 3622063 B
- US 3276868 A
- US 4153461 A
- US 4689272 A
- JP 2001199175 A
- JP 2002079772 A
- JP 10282679 A
- JP 2304441 A
- JP 2005125749 A
- JP 5045885 A
- JP 6035174 A
- US 3458311 A
- JP 55049729 B
- US 292501 A

- US 44563 A
- JP 2220061 A
- JP 60059351 A
- US 5148746 A
- US 5568768 A
- GB 2297719 A
- JP 58159533 A
- JP 3100554 A
- JP 62167253 B

**Non-patent literature cited in the description**


- *Adhesion,* 1984, vol. 20 (7), 300-308
- Senryo Binran. The Synthetic Organic Chemistry, 1970
- Saishin Ganryo Binran. Nippon Ganryo Gijutsu Kyokai, 1977
- Saishin Ganryo Oyo Gijutsu. CMC Shuppan, 1986
- Insatsu Ink Gijutsu. CMC Shuppan, 1984
- Kinzoku Sekken no Seishitsu to Oyo. **Saiwai Shobo.** Insatsu Ink Gijutsu. CMC Shuppan, 1984